Europäisches Patentamt

European Patent Office

Office européen des brevets

(19)

(11) **EP 0 856 956 A1**

(12) **EUROPEAN PATENT APPLICATION**

(43) Date of publication:
**05.08.1998 Bulletin 1998/32**

(51) Int Cl.6: **H04B 7/08**, H03M 7/40

(21) Application number: **98300067.0**

(22) Date of filing: **07.01.1998**

(84) Designated Contracting States:
**AT BE CH DE DK ES FI FR GB GR IE IT LI LU MC NL PT SE**
Designated Extension States:
**AL LT LV MK RO SI**

(30) Priority: **30.01.1997 US 790416**

(71) Applicant: **AT&T Corp.**
**New York, NY 10013-2412 (US)**

(72) Inventors:
• **Orchard, Michael Thomas**
  **Princeton, New Jersey 08540 (US)**

• **Reibman, Amy Ruth**
  **Matawan, New Jersey (US)**
• **Wang, Yao**
  **Matawan, New Jersey 07747 (US)**

(74) Representative: **Harding, Richard Patrick et al**
  **Marks & Clerk,**
  **4220 Nash Court,**
  **Oxford Business Park South**
  **Oxford OX4 2RU (GB)**

(54) **Multiple description coding communication system**

(57)    A multiple description coder 20 pairs two samples and transforms the samples prior to quantizing and entropy encoding to improve coding efficiency while simultaneously achieving satisfactory performance with regard to distortion. For the N-Sample case, the multiple description coder pairs the samples using two different algorithms, and then performs the pairing transformation of the two variable case. One method assigns the lowest energy coefficients with the highest energy coefficients and so on until the middle coefficients are paired with each other. Another method assigns the highest energy coefficient with coefficients having energy below some predetermined value. Image coders and decoders are also included. A method for classifying the coefficients prior to performing the pairing transform is disclosed, which classifies the coefficients according to the amount and location of their energy.

## FIG. 2

**Description**

BACKGROUND OF THE INVENTION

The present invention relates generally to communication systems, and more particularly to a communication system for communicating through unreliable channels, i.e., channels that have relatively high long burst errors and intermittent failures.

An example of such a communication system, for example, is a wireless channel where long burst errors can occur due to the fading effect and where a physical link can be down temporarily because of an intermediate blocking. When transmitting image signals over such channels, these channel errors can lead to the loss of a large portion of the image if conventional image coders are used to code the image. For example, with a JPEG coder, the loss of a few bits in a block can make the current block and all the following blocks in a now undecodable.

One way to enhance the reliability of communication system is by using multiple description coding (MDC) at the source coder. With MDC, several coded bit-streams (referred to as descriptions) of the same signal are generated. The coder is designed so that a better signal reproduction can be achieved with more descriptions, but the quality of the decoded signal is at least minimally acceptable even with only one description.

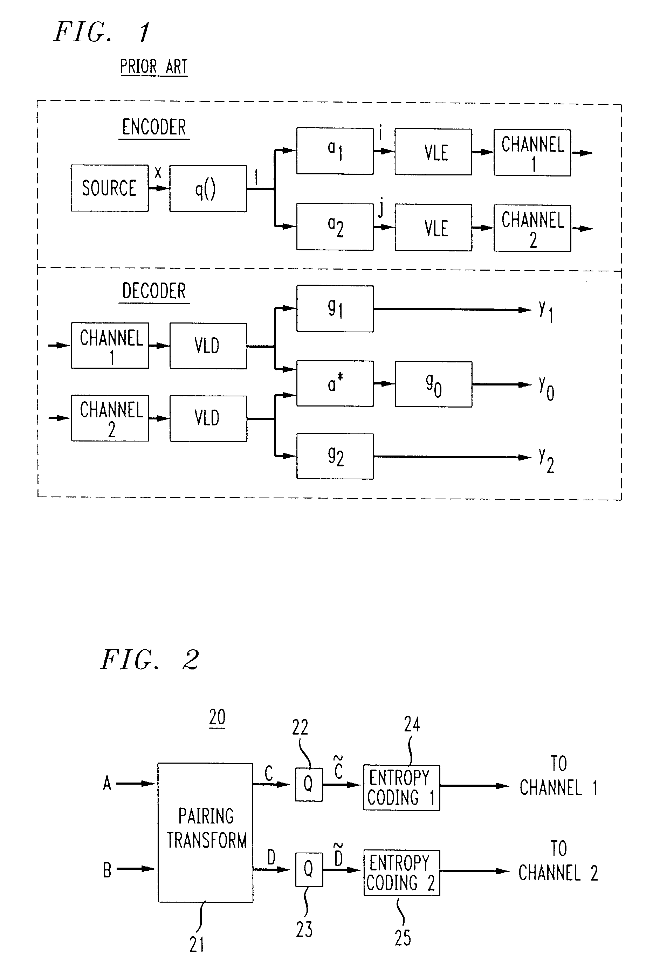

FIG 1 illustrates a known two description coder and an associated channel model. It can be seen that the source end requires two encoders, which generate two descriptions; whereas the receiving end demands three decoders, among which only one functions at a time depending on whether stream one only, or stream two only, or both steams are received.

Let $R_1$ and $R_2$ represent the bit rates used for the two descriptions, respectively. Let $E_2(R_1, R_2)$ represent the reconstruction error when both descriptions are received, and let $E_{1,1}(R_1)$ and $E_{1,2}(R_2)$ represent the reconstruction error when only first and second descriptions are available, respectively. The design of a multiple description coder can be stated as follows: Given $R_1$, $R_2$, minimize $E_2(R_1, R_2)$ subject to a constraint

$$E_{1,1}(R_1) \le E_{e_1} \ and \ E_{1,2}(R_2) \le E_{e_2} \tag{1}$$

where $E_{e1}$ and $E_{e2}$ are the maximum acceptable error if only the first and second descriptions are available, respectively. In many applications, it is desirable to further require that the two descriptions by symmetric, i.e.,

$$\begin{aligned} R_1 &= R_2 = R \ and \\ E_{1,1}(R) &= E_{1,2}(R) = E_1(R) \ and \\ E_{e_1} &= E_{e_2} = E_e \end{aligned} \tag{2}$$

Next, we consider the design of such a symmetric multiple description coder. The problem can be stated as: Given R, minimize $E_2(R)$ subject to a constraint $E_1(R) \le Ee$.

Let $p_i$, $i = 0, 1, 2$ represent the probabilities that none, one, or two descriptions are received, respectively. If we assume that the probability that either description is lost is p, then the probabilities that 0, 1, and 2 symbols are received are,

$$\begin{aligned} p_0 &= p^2 \\ p_1 &= p(1-p) \\ p_2 &= (1-p)^2 \end{aligned} \tag{3}$$

respectively. $E(R, p_2, p_1, p_0)$ can then be written as E (R, p). The average distortion achievable with the above symmetric two description coder is therefore:

$$E(R,p_0,p_1,p_2) = p_2 E_2(R) + p_1 E_1(R) + p_0 E_0 \qquad (4)$$

where $E_0$ stands for the distortion when none of the descriptions is received. This error should be equal to the signal variance. Rather than putting a constraint on the distortion incurred when only one description is available (i.e., requiring $E_1(R) < E_e$), another plausible criterion for designing a multiple description coder is: Given R and p, minimize the average distortion E (R, p).

Multiple description coding was first studied from a rate-distortion theory point of view. The motivation behind MDC is to combat signal loss due to path failures. To realize this goal, each coded stream (i.e., a description) must carry sufficient information about the original signal. Essentially this requires a certain degree of redundancy be embedded between the multiple descriptions. This will reduce coding efficiency compared to conventional signal description coding (SDC).

Wolf, J. K., Wyner, A., and Ziv, J., "Source Coding for Multiple Descriptions," <u>The Bell System Technical Journal,</u> vol. 59, pp. 1417-1426, Oct. 1980 showed that given a total bit rate 2R, the minimum distortion achievable by a single description coder, $E_{min}$ (2R), is less than the minimal distortion achievable by a multiple description coder when both descriptions are available, $E_2(R_1, R_2)$, if $R_1 + R_2 = 2R$. Wolf et al. showed this using a rate distortion analysis for an independent identically distributed binary source.

Ozarow, L., "On a Source Coding Problem With Two Channels and Three Receivers," <u>The Bell System Technical Journal</u>, Vol. 59, p. 1921, Dec. 1980 also showed that the performance of a single description coder is better than the performance of a multiple description coder when both descriptions are available in the case of an independent identically distributed Gaussian source.

Specifically, Ozarow showed that if each coder is optimal in the rate distortion sense, i.e., $E_{1,j}(R_j)$ is minimized for a given $R_j$, then the joint coder will be far from optimal, i.e., $E_2(R_1, R_2)$ is much larger than the minimal distortion achievable for this source $E_{min}(R_1 + R_2)$. The converse is also true: if the joint coder is optimal, i.e., $E_2(R_1, R_2) \approx E_{min}(R_1 + R_2)$, then either one of the coders will be far from optimal, i.e., $E_{1,j}(R)$ is much larger than $E_{min}(R)$ for j = 1 or j = 2 or both.

With real image and video signals, the redundancy in the signal (such as correlation among adjacent samples) can help reduce the loss in coding efficiency, but a certain amount of sacrifice in coding efficiency is unavoidable. However, this reduced coding efficiency is in exchange for increased robustness to long burst errors and/or channel failures. With SDC, one would have to spend many error-control bits and/or introduce additional latency to correct such channel errors. With MDC, a long burst error or even the loss of one description does not have a catastrophic effect, as long as not all the descriptions are experiencing failures simultaneously. Thus, one could use fewer error control bits for each description. In this sense, the MDC is a way of performing joint source and channel coding.

The first practical multiple description coder was proposed for speech coding. In this approach, the bitstream from a DPCM coder is split into even and odd sample packets. If an even (odd) sample packet is lost, data contained in the odd (even) sample packet are used to interpolate the missing even (odd) samples. It was shown that this coder works well beyond what the analysis predicted. This is in part because the analytical results hold true at the rate-distortion limit, while the bit rates in their proposed coder are nowhere close to the rate-distortion limit. In fact, there is sufficient redundancy left in the coder output, to permit subsampling and high quality interpolation.

In another approach to MDC, multiple descriptions are obtained by quantizing each sample using two quantizers. The quantizers are designed so that the combination of the two quantizers leads to a finer quantizer, while each quantizer itself is a coarse quantizer. The simplest implementation of this approach uses two quantizers whose decision regions shift by half of the quantizer interval with respect to each other. In this case, 2R bits are required to match the performance of a single quantizer with R+1 bits. Therefore, the loss in coding efficiency is quite significant, for R relatively high. Although more sophisticated quantizer mappings can be designed to improve the coding efficiency, a direct application of this approach to the original samples of a signal is not advisable in terms of loss in coding efficiency. Recently, this approach has been applied to transform coefficients in transform coders, with applications in both speech, image, and video. The loss in coding efficiency is less severe in this case, but still quite high, up to 30%.

The present invention is therefore directed to the problem of developing a method and apparatus for performing multiple description coding that improves the coding efficiency while simultaneously providing similar estimation accuracy. In addition, the present invention is directed to the problem of applying such a method and apparatus to image coding.

<u>SUMMARY OF THE INVENTION</u>

The present invention solves this problem for a two sample system by performing a pairing transformation on the two samples prior to quantizing and encoding. Each transformed sample is then quantized and encoded separately and then transmitted over different channels. On the decoding side, the decoder first determines which channels are working, and entropy decodes and quantizes each channel. The decoder then performs an inverse pairing transform on the outputs of the quantizers. The inverse pairing transform performs three different transformations depending upon which channels are working, i.e., whether the first, second or both channels are working.

According to the present invention for an N-Sample block, the block is first converted to N/2 sample pairs, which are then processed as in the two variable method. On the decoder side, the process is similar to the two sample decoder, except that the pair must be reordered to their original order after the inverse pairing transform.

In one advantageous embodiment of the present invention for the N-Sample case, the block of coefficients is split into two equal sized subblocks. Processing then proceeds as before.

In another advantageous embodiment of the present invention, the block of coefficients is segmented into two parts -- the first part containing coefficients with relatively large energies and the second part containing coefficients with relatively small energies. Each of the parts is then processed differently. The first part coefficients are assigned to the two streams in the pairing arrangement discussed above, while the coefficients in the second part are alternately assigned to the two streams.

According to another element of the present invention, the pairing of the coefficients occurs as follows. The coefficients with the largest energy are paired with the coefficients with the smallest energy in this part. Then the coefficients with the second largest and second smallest energies are paired, and so on until the coefficients in the middle are paired with each other. This pairing technique can be implemented in any of the two N-Sample MDC Coders discussed above.

In an alternate embodiment of the pairing technique of the present invention, the coefficient with the largest energy can be paired with a coefficient having an energy less than a predetermined value, and so on until all pairing assignments are complete. One advantageous implementation of this embodiment occurs when the predetermined value equals the variance of largest coefficient times the estimation error divided by the difference between the variance of the largest coefficient and the estimation error. The end result of using this value is that each paired sample is coded with the maximum variance possible.

According to yet another embodiment of the present invention, for certain types of applications the coefficients are placed in three groups -- those with the highest energies, those having energies in the middle and those with the lowest energies. The highest energy coefficients are duplicated on each channel, the middle level energy coefficients are paired as before, and the lowest energy coefficients are alternately assigned to each channel. On the decoder side, the process is similar to the other decoders, except that the duplicated samples must be separately processed from the other samples..

According to yet another embodiment of the present invention, the coefficients are classified according to their energy content. The different classes are then processed differently. On the decoder side the classification information that is received with the samples is used to determine the assignment of coefficients.

It is particularly advantageous if the classifications of coefficients are defined as smooth, vertical, horizontal, and random, where smooth includes those coefficients having most of their energy in low frequencies or having a minimum amount of energy, where vertical includes those coefficients having most of their energy in the vertical direction, where horizontal includes those coefficients having most of their energy in the horizontal direction, and where random includes those coefficients not having been included in any of the previous classifications.

BRIEF DESCRIPTION OF THE DRAWINGS

FIG 1 depicts a prior art multiple description coder and decoder for the two description case.

FIG 2 depicts a block diagram of the multiple description coder for the two variable case according to the present invention

FIG 3 depicts the pairing transform used in the present invention.

FIG 4 depicts a block diagram of the decoder for the two variable case according to the present invention for use with the coder of FIG 2.

FIG 5 depicts the inverse pairing transform used in the present invention.

FIG 6 depicts a block diagram of the N-Sample Multiple Description Encoder according to the present invention.

FIG 7 depicts one embodiment for pairing samples in the N-Sample case according to the present invention.

FIG 8 depicts another embodiment for pairing samples in the N-Sample case according to the present invention.

FIG 9 depicts a block diagram of the N-Sample Multiple Description Decoder according to the present invention for use with the Encoder of FIG 6.

FIGs 10-11 depicts a block diagram of one embodiment an N-Sample Multiple Description Image Encoder according to the present invention.

FIG 12 depicts an algorithm for classifying coefficients according to the present invention.

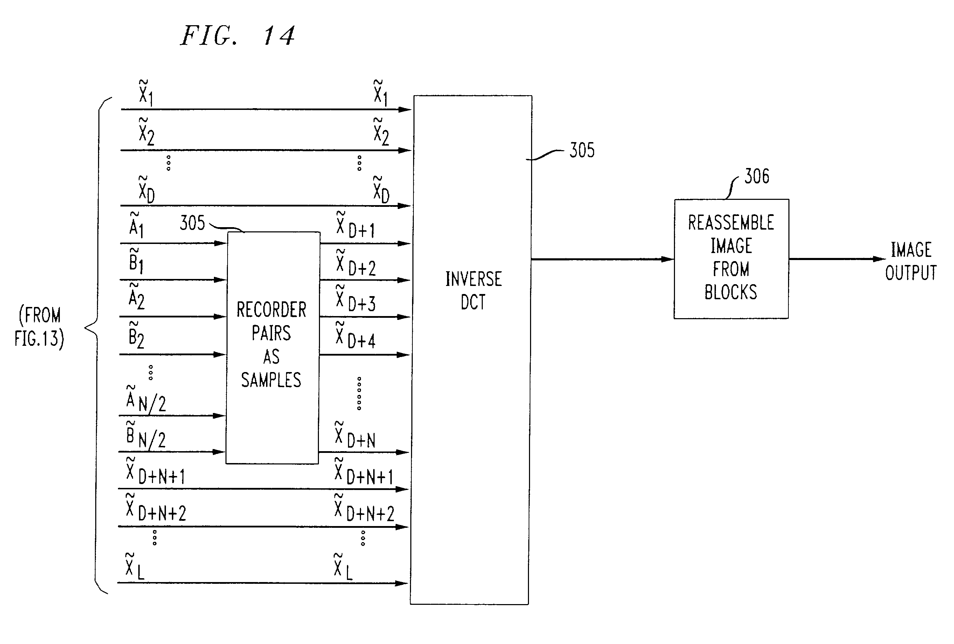

FIGs 13-14 depict a block diagram for another embodiment of an N-Sample Multiple description Image Decoder according to the present invention for use with the Encoder of FIGs 10-11.

DETAILED DESCRIPTION

The present invention modifies a conventional block transform coder to realize a Multiple Description Coder (MDC). Given a block of L samples, as in the conventional transform coder, these samples are first transformed to L coefficients using a Discrete Cosine Transform (DCT), for example. It is possible to use another type of transform, however.

Instead of directly quantizing and coding these coefficients, the present invention converts them to two streams of variables, with L/2 variables in each stream. The variables in each stream are quantized, coded, and transmitted independently. Ideally, the conversion is such that if both streams are received, then the original transform coefficients can be recovered perfectly in the absence of the quantization error. If only one stream is received, the original transform coefficients can still be recovered to a certain accuracy.

This is accomplished by segmenting the L coefficients into two parts. The first part contains $N \leq L$ coefficients with relatively large energies, whereas the second part consists of L - N coefficients with small energies. These two parts are then processed differently.

As the first part contains significant coefficients, none of the coefficients are allowed to be thrown away in either stream. On the other hand, repeating these coefficients in both streams will lead to too much loss in coding efficiency. To obtain a better compromise between the quality and coding efficiency, a pairing mechanism is employed, which will be explained later.

For the second part, the coefficients are split between the two streams evenly, i.e., even indexed coefficients are put into stream one, and odd indexed coefficients are put into stream two. If, for example, only stream one is received, then the odd coefficients are simply replaced by zeros. Because these coefficients have small variances, their loss does not cause a severe visual distortion.

Returning to the first part, with the proposed pairing method, the N coefficients are grouped into N/2 pairs, and each pair is transformed into another two variables, which are put into the two streams separately. The pairing and transformation are designed so that from any one variable, the original pair can be estimated to a satisfactory degree. This essentially requires that a large (in terms of variance) coefficient be paired with a small coefficient, so that the large coefficient is almost coded twice. Obviously, doing so reduces the coding efficiency as with any multiple description coder. A key issue is how to pair the coefficients so that a good trade-off-between the estimation accuracy and coding efficiency is reached.

**Two Variable Case**

As described above, a basic constituent of the MDC algorithm of the present invention is the coding of pair of variables. Instead of coding the two variables independently, they are transformed into two other variables, which are quantized and transmitted separately. In the receiver, if both transformed variables are available, they are inversely transformed to recover the original two variables. If only one transformed variable is received, one must be able to estimate the original two variables. The transformation is such that from any one transformed variable, the original two variables can be estimated to a certain accuracy, and that the estimation errors for the two variables are the same. Further, the transform is unitary so that the mean square quantization error added to the transformed variables is the same as that added to the original variables.

**The Optimal Transform for Generating Two Equivalent Descriptions and the Optimal Linear Estimators**

In order to show what transform will satisfy our requirement, we first introduce Lemma 1. We then state the optimal transform and estimators in Theorem 1. The proof for both will be provided later.

Lemma 1: Given two RVs, A and B, assume they are uncorrelated, with zero means and variances $\sigma_a^2$ and $\sigma_b^2$. If

$$C = \alpha A + \beta B \qquad (5)$$

then the best linear estimators for A and B from C are

$$\hat{A} = \gamma_a C \ and \ \hat{B} = \gamma_b C \qquad (6)$$

with

$$\gamma_a = \frac{\alpha\sigma_a^2}{\alpha^2\sigma_a^2 + \beta^2\sigma_b^2} \tag{7}$$

$$\gamma_b = \frac{\beta^2\sigma_a^2\sigma_b^2}{\alpha^2\sigma_a^2 + \beta^2\sigma_b^2} \tag{8}$$

The mean square estimation errors are:

$$E_{e,a,min} = \frac{\beta^2\sigma_a^2\sigma_b^2}{\alpha^2\sigma_a^2 + \beta^2\sigma_b^2} \tag{9}$$

$$E_{e,b,min} = \frac{\alpha^2\sigma_a^2\sigma_b^2}{\alpha^2\sigma_a^2 + \beta^2\sigma_b^2} \tag{10}$$

Theorem 1: Given two RVs, A and B, with the same properties as specified in Lemma 1, it is desired to construct a linear transformation of {A,B} to {C,D}, so that the linear estimation errors of A and B from either C or D are the same and this error is minimized, and that the transformation is energy preserving so that variances $\sigma_c^2 + \sigma_d^2 = \sigma_a^2 + \sigma_b^2$. The only solution is the unitary transform:

$$\left\{ \begin{array}{l} C = \dfrac{1}{\sqrt{2}}(A+B) \\[2ex] D = \dfrac{1}{\sqrt{2}}(A-B) \end{array} \right\} \tag{11}$$

Further, the best linear predictors and the prediction errors are:

$$\left\{ \begin{array}{l} \hat{A}(C) = \gamma_{ca}C, \ with \ \gamma_{ca} = \dfrac{\sqrt{2}\sigma_a^2}{\sigma_a^2 + \sigma_b^2}, \\[3ex] \hat{B}(C) = \gamma_{cb}C, \ with \ \gamma_{cb} = \dfrac{\sqrt{2}\sigma_b^2}{\sigma_a^2 + \sigma_b^2}, \end{array} \right\} \tag{12}$$

$$\begin{cases} \hat{A}(D) = \gamma_{da}D, \; with \; \gamma_{da} = \dfrac{\sqrt{2}\sigma_a^2}{\sigma_a^2 + \sigma_b^2}, \\[2em] \hat{B}(D) = \gamma_{db}D, \; with \; \gamma_{db} = \dfrac{-\sqrt{2}\sigma_b^2}{\sigma_a^2 + \sigma_b^2}, \end{cases} \qquad (13)$$

$$E_{e,\min} = E_{e,a,\min} = E_{e,b,\min} = \frac{\sigma_a^2\sigma_b^2}{\sigma_a^2+\sigma_b^2} \qquad (14)$$

**The Single and Multiple Description Coders for Two Variables**

Consider the coding and transmission of A and B through two independent and equal channels. Suppose we code and transmit these two RVs independently. If one channel undergoes a failure so that A or B is lost, because A and B are independent, the best estimate of A or B is by the respective mean, and the corresponding estimation error is $\sigma_a^2$ or $\sigma_b^2$. If one RV, for example A, has a significantly higher variance than B, then the failure of the channel carrying A will lead to a large error.

Theorem 1 suggests that we could transform A and B into C and D using the unitary transform described in (11). If both C and D are received, we can use an inverse of (11), which is simply:

$$\begin{cases} A = \dfrac{1}{\sqrt{2}}(C + D), \\[1.5em] B = \dfrac{1}{\sqrt{2}}(C - D). \end{cases} \qquad (15)$$

If only C or D are received, then we can use the estimator in (12) or (13) to estimate A and B. The estimation errors for A and B from either C or D would be the same, as described in (14).

We will refer to the first coder which directly codes A and B as the two variable single description coder (SDC2) and the second coder which codes C and D the two variable multiple description coder (MDC2).

In the following subsections, we will analyze and compare the rate-distortion performances of these two coders. To simplify the analysis, we assume that A and B, hence C and D, are uniform random variables (RVs) and in either the SDC2 or MDC2, uniform scalar quantization is used for quantizing A and B or C and D. In the following analysis, we will make use of the well-known result in the quantization theory - when applying a uniform quantizer to a uniform RV, the mean square quantization error $E_q$ is associated with the variance of the signal $\sigma^2$ and the bit rate R by:

$$E_q = \sigma^2 2^{-2R} \qquad (16)$$

Note that we are mostly interested in the relative performance of the multiple description coding verses single description coding. Although the assumption that all the RVs are uniform is quite restrictive, the relative gains/losses derived based on this assumption should provide a good insight for the more general cases, as the same assumption is applied to both SDC and MDC.

**Analysis of the SDC2:**

Let R represent the average number of bits specified for representing A and B. The best bit allocation that minimizes the total quantization error for A and B is:

$$
\left\{
\begin{array}{l}
R_a = R + \dfrac{1}{2}\log_2 \dfrac{\sigma_a^2}{\sqrt{\sigma_a^2 \sigma_b^2}} = R - \dfrac{1}{4}\log_2 \lambda, \\[4mm]
R_b = R + \dfrac{1}{2}\log_2 \dfrac{\sigma_b^2}{\sqrt{\sigma_a^2 \sigma_b^2}} = R + \dfrac{1}{4}\log_2 \lambda.
\end{array}
\right\}
\qquad (17)
$$

where

$$
\lambda = \frac{\sigma_b^2}{\sigma_a^2} \qquad (18)
$$

is the variance ratio between the two RVs. The quantization error is

$$
E_{q,a} = E_{q,b} = \sqrt{\sigma_a^2 \sigma_b^2 2^{-2R}} \qquad (19)
$$

With SDC2, if both $\tilde{A}$ (quantized A) and $\hat{B}$ (quantized B) are received, then the reconstruction error per symbol is simply the quantization error:

$$
E_{SDC2,2} = \frac{1}{2}(E_{q,a} + E_{q,b}) = \sqrt{\sigma_a^2 \sigma_b^2 2^{-2R}} \qquad (20)
$$

If only $\tilde{A}$ is received, and the missing B is estimated by its mean, then the reconstruction error is

$$
E_{q,a} + \sigma_b^2 \qquad (21)
$$

Similarly, if only $\tilde{B}$ is received, the reconstruction error is

$$
E_{q,b} + \sigma_a^2. \qquad (22)
$$

Assuming the probabilities of losing A and B are equal, the average reconstruction error per symbol is:

$$
\begin{aligned}
E_{SDC2,1} &= \frac{1}{2}\left( \frac{1}{2}(E_{q,a} + \sigma_b^2) + \frac{1}{2}(E_{q,b} + \sigma_a^2) \right) \\[2mm]
&= \frac{1}{2}\sqrt{\sigma_a^2 \sigma_b^2}\, 2^{-2R} + \frac{1}{4}(\sigma_a^2 + \sigma_b^2)
\end{aligned}
\qquad (23)
$$

Finally, if both A and B are lost, the reconstruction error is:

$$
E_{SDC2,0} = \frac{1}{2}(\sigma_a^2 + \sigma_b^2)
$$

Finally, the average error for given channel loss rates $p_0$, $p_1$, $p_2$ is:

$$E_{SDC2} = p_2 E_{SDC2,2} + p_1 E_{SDC2,1} + p_0 E_{SDC2,0}$$
$$= \left(p_2 + \frac{p_1}{2}\right)\sqrt{\sigma_a^2 \sigma_b^2} 2^{-2R} + \left(\frac{p_1}{2} + p_0\right)\frac{(\sigma_a^2 + \sigma_b^2)}{2} \qquad (25)$$

**Analysis of the MDC2:**

For the MDC2, because

$$\sigma_c^2 = \sigma_d^2 = (\sigma_a^2 + \sigma_b^2)2^{-2R} \qquad (26)$$

it is natural to let $R_c = R_d = R$, and the associated quantization error is:

$$E_{q,c} + E_{q,d} = \frac{1}{2}\left(\sigma_a^2 + \sigma_b^2\right)2^{-2R} \qquad (27)$$

The reconstruction error in the presence of both C and D is simply the quantization error for C and D because the transformation in (11) is unitary. Thus, we have

$$E_{MDC2,2} = \frac{1}{2}( E_{q,c} + E_{q,d}) = \frac{1}{2}(\sigma_a^2 + \sigma_b^2)2^{-2R} \qquad (28)$$

If, for example, only the quantized C, $\tilde{C} = C + q_c$ is received, the estimation error from $\tilde{C}$ to A is:

$$E_{e,a}(\tilde{C}) = E\left\{(A - \gamma_{ca}\tilde{C})^2\right\} = E\left\{(A - \gamma_{ca}C)^2\right\} + E\left\{\gamma_{ca}^2 q_c^2\right\} \qquad (29)$$

$$= E_{e,min} + \gamma_{ca}^2 E_{q,c} = \frac{\sigma_a^2 \sigma_b^2}{\sigma_a^2 + \sigma_b^2} + \frac{\sigma_a^4}{\sigma_a^2 + \sigma_b^2}2^{-2R} \qquad (30)$$

In deriving the above result, we have assumed that the quantization error $q_c$ is uncorrelated with A or C. Similarly, we can obtain:

$$E_{e,b}(\tilde{C}) = \frac{\sigma_a^2 \sigma_b^2}{\sigma_a^2 + \sigma_b^2} + \frac{\sigma_a^4}{\sigma_a^2 + \sigma_b^2}2^{-2R} \qquad (31)$$

$$E_{e,a}(\tilde{D}) = \frac{\sigma_a^2 \sigma_b^2}{\sigma_a^2 + \sigma_b^2} + \frac{\sigma_a^4}{\sigma_a^2 + \sigma_b^2} 2^{-2R} \tag{32}$$

$$E_{e,b}(\tilde{D}) = \frac{\sigma_a^2 \sigma_b^2}{\sigma_a^2 + \sigma_b^2} + \frac{\sigma_b^4}{\sigma_a^2 + \sigma_b^2} 2^{-2R} \tag{33}$$

The average reconstruction error per symbol when only $\check{C}$ or $\check{D}$ is available is:

$$E_{MDC2,1} = \frac{1}{2}\left( \frac{1}{2}\left( E_{e,a}(\tilde{C}) + E_{e,b}(\tilde{C}) \right) + \frac{1}{2}\left( E_{e,a}(\tilde{D}) + E_{e,b}(\tilde{D}) \right) \right) \tag{34}$$

$$= \frac{\sigma_a^2 \sigma_b^2}{\sigma_a^2 + \sigma_b^2} + \frac{\sigma_a^4 + \sigma_b^4}{2(\sigma_a^2 + \sigma_b^2)} 2^{-2R} \tag{35}$$

Obviously, the error when both $\check{C}$ and $\check{D}$ and are absent is the same as in the SDC2, i.e.,

$$E_{MDC2,0} = \sigma_a^2 + \sigma_b^2 \tag{36}$$

The average error for given channel loss rates $p_0$, $p_1$, $p_2$ is:

$$E_{MDC2} = p_2 E_{MDC2,2} + p_1 E_{MDC2,1} + p_0 E_{MDC2,0} \tag{37}$$

**Comparison of SDC2 and MDC2**

The inventors compared the various types of errors derived above for the SDC2 and MDC2. In the presence of both channels, the SDC2 performss better, while in the presence of one channel, the MDC2 performs better for relatively high bit rate.

To obtain more quantitative comparison of these two coders, let us consider the quantization errors when the bit rate is fixed. From (28) and (20), we find

$$\frac{E_{MDC2,2}}{E_{SDC2,2}} = \frac{\sigma_A^2 + \sigma_B^2}{2\sqrt{\sigma_A^2 \sigma_B^2}} = \frac{1 + \lambda}{2\sqrt{\lambda}} \quad r \geq 1 \tag{38}$$

which is equal to the ratio r between the arithmetic mean and geometric mean of $\sigma_a^2$ and $\sigma_b^2$. This ratio is one only when $\sigma_a^2 = \sigma_b^2$. Otherwise, it is greater than one, implying that the MDC2 will lose coding efficiency whenever the two variables have different variances, and the loss is more significant when they differ more substantially.

In terms of the loss in the Signal to Noise Ratio (SNR) when both channels are available, we have,

$$\Delta SNR_2 = SNR_{SDC2} - SNR_{MDC2} = 10\log_{10} \frac{E_{MDC2,2}}{E_{SDC2,2}} = 10\log_{10} r \tag{39}$$

It is interesting to note that the loss in the SNR is independent of the bit rate, R.

Similarly, we can compare the performances of the two coders in the presence of only one signal. To simplify the analysis, we assume that the bit rate is relatively high, so that the quantization error is small compared to the estimation error. In this case, from (23 and 34-35), we have

$$E_{SDC2,1} \approx \frac{\left(\sigma_a^2 + \sigma_b^2\right)}{2}, \; E_{MDC2,1} \approx \frac{2\sigma_a^2\sigma_b^2}{\sigma_a^2 + \sigma_b^2} \tag{40}$$

Therefore,

$$\frac{E_{SDC2,1}}{E_{MDC2,1}} = r^2 \tag{41}$$

$$\Delta SNR_1 = 10\log_{10} \frac{E_{SDC2,1}}{E_{MDC2,1}} = 20\log_{10} r = 2\Delta SNR_2 \tag{42}$$

This means that 1dB loss in the coding efficiency will yield 2 dB gain in the estimation accuracy in the presence of one channel only.

With MDC2, the loss in coding efficiency, i.e., $\Delta SNR_2$, is more significant when the two variables differ more in their variances, i.e., when $\lambda$ is small or r is large. On the other hand, the gain in estimation error in the presence of one channel, i.e., $\Delta SNR_1$ is also more substantial. For a fixed $\lambda$, the choice between the SDC2 and MDC2 depends on the channel loss probability p.

Next, let us compare the bit rates required by the two coders under the same quantization error. Let

$$E_{q,a} = \sigma_a^2 2^{-2R^a} = E_{q,b} = \sigma_b^2 2^{-2R^b} = E_q \tag{43}$$

we obtain the average bit rate required by the SDC2 is

$$R_{SDC} = \frac{1}{2}(R_a + R_b) = \frac{1}{2}\log_2 \frac{\sqrt{\sigma_a^2\sigma_b^2}}{E_q} \tag{44}$$

With the MDC2, we can obtain in a similar way:

$$R_{MDC2} = \frac{1}{2}(R_c + R_d) = \frac{1}{2}\log_2 \frac{\sqrt{\sigma_c^2\sigma_d^2}}{E_q} = \frac{1}{2}\log_2 \frac{\sigma_a^2 + \sigma_b^2}{2E_q} \tag{45}$$

Therefore, the increase in the bit rate per sample for the same quantization error is:

$$\Delta R = R_{MDC2} - R_{SDC2} = \frac{1}{2} \log_2 \frac{\sigma_a^2 + \sigma_b^2}{2\sqrt{\sigma_a^2 \sigma_b^2}} = \frac{1}{2} \log_2 r$$

Substituting (46) into (42), we obtain

$$\Delta SNR_e = 40 \log_{10} 2\Delta R \approx 12 \Delta R \tag{47}$$

This means each extra bit used by the MDC2 reduces the estimation error by 12 dB compared to the SDC2. On the other hand, it is well known that an extra bit can only reduce the quantization error in the SDC2 by 6 dB.

Note that if the RVs A and B were obtained by a 2 point unitary transform of two consecutive samples in a normal transform coder, then the MDC2 simply undoes the transform and codes the original 2 samples directly with a scalar quantizer. Obviously, we will lose all the gain by transform coding, which is not our intention. As described in the introduction, the coder for the two variable case will be used for selected N/2 pairs of coefficients in a L point transform. The coder for the N variable case is described next.

## The N Variable Case

In this section we consider the case where N RVs $X_n$, $n = 1, 2, ..., N$ are to be split into two streams, each with N/2 samples. The requirement is that if only one stream is available, one can still obtain a reasonably accurate representation of all N RVs, and that the reconstruction error in the presence of either channel is the same. As earlier, we will assume that these RVs are uncorrelated with each other, have zero means and variances $\sigma_n^2$. We further assume, without the loss of generality, that these RVs are ordered so that

$$\sigma_n^2 > \sigma_{-1}^2 \tag{48}$$

One way to generate two descriptions from N RVs is to first quantize the N RVs using optimal bit allocation, and then split the quantized coefficients into two streams so that each stream contains N/2 coefficients. The splitting can be arbitrary, for example, one can put even symbols, $X_{2m}$, $m = 1, 2, ..., N/2$ into one stream, and odd symbols, $X_{2m+1}$, $m = 1, 2, ..., N/2$ into another stream. If only one stream is received, because the symbols in the two streams are uncorrelated, the best estimate is to replace each missing symbol by its mean value so that the estimation error is equal to its variance. Obviously, losing either stream will yield large reconstruction error. If one stream happens to contain more significant coefficients, the loss of that stream will lead to a larger error. We will refer to this coder as the N variable single description coder (SDCN).

In order to produce two "equivalent" streams and to enable the estimation of the original N RVs from any one stream, one way is to group the N RVs into N/2 pairs and apply the MDC2 discussed in the previous section to each pair. For each pair $A_m = X_{n(m,1)}$, $B_m = X_{n(m,2)}$, $m = 1, 2, ..., N/2$, the MDC2 generates two symbols $C_m$, $D_m$, which are transmitted over two separate channels. If only one stream, $C_m$ or $D_m$, is available, one can estimate both $A_m$, $B_m$ from either $C_m$ or $D_m$. We will refer to this coder as the N variable multiple description coder (MDCN).

## Analysis of the SDCN

Let $R$ represent a prescribed average bit rate per symbol. It is known that the optimal bit allocation among the N RVs that minimize the average quantization error is as in (45).

$$R_n = R + \log_2 \left[ \frac{\sigma_n^2}{\left( \prod \sigma_n^2 \right)^{\frac{1}{N}}} \right], \quad n = 1, 2, ..., N \tag{49}$$

The associated quantization error for any symbol is:

$$E_{q,n} = \left(\prod \sigma_n^2\right)^{\frac{1}{N}} 2^{-2R} \qquad (50)$$

The reconstruction error per symbol in the presence of both streams is simply the above quantization error, i.e.,:

$$E_{SDCN,2} = \left(\prod \sigma_n^2\right)^{\frac{1}{N}} 2^{-2R} \qquad (51)$$

On the other hand, the reconstruction error when only stream one or two is available is:

$$E_{SDCN1,1} = \frac{1}{N}\left(\sum_{n \in stream\ 1} E_{SDCN,q,n} + \sum_{n \in stream\ 2} \sigma_n^2\right) \qquad (52)$$

$$E_{SDCN1,2} = \frac{1}{N}\left(\sum_{n \in stream\ 2} E_{SDCN,q,n} + \sum_{n \in stream\ 1} \sigma_n^2\right) \qquad (53)$$

Assuming the probability that either stream is lost is equal, then the average reconstruction error when only one stream is available is:

$$E_{SDCN,1} = \frac{1}{2}\left(\prod \sigma_n^2\right)^{\frac{1}{N}} 2^{-2R} + \frac{1}{2N}\sum_{n=1}^{N} \sigma_n^2 \approx \frac{1}{2N}\sum_{n=1}^{N} \sigma_n^2 \qquad (54)$$

The reconstruction error when both streams are lost is:

$$E_{SDCN,0} = \frac{1}{N}\sum_{n=1}^{N} \sigma_n^2 \qquad (55)$$

The average error for channel loss rates $p_0$, $p_1$ and $p_2$ is:

$$E_{SDCN} = p_2 E_{SDCN,2} + p_1 E_{SDCN,1} + p_0 E_{SDCN,0}$$

$$= \left(p_2 + \frac{p_1}{2}\right)\left(\prod \sigma_n^2\right)^{\frac{1}{N}} 2^{-2R} + \left(\frac{p_1}{2} + p_0\right)\frac{1}{N}\sum_{n=1}^{N} \sigma_n^2 \qquad (57)$$

**Analysis of the MDCN**

In the MDCN, for each stream we are coding $N/2$ variables with variances

$$\sigma^2_m = \frac{\left(\sigma^2_{n(m,1)} + \sigma^2_{n(m,2)}\right)}{2} \tag{58}$$

where $\sigma^2_{n(m,1)}$ and $\sigma^2_{n(m,2)}$ are the variances of $A_m$ and $B_m$, respectively. The optimal bit allocation is

$$R_m = R + \log_2 \frac{\sigma^2_m}{\left(\prod \sigma^2_m\right)^{\frac{2}{N}}}, \quad m = 1, 2, ..., N/2 \tag{59}$$

and the associated quantization error is

$$E_{MDCN,q,m} = \left(\prod \sigma^2_m\right)^{\frac{2}{N}} 2^{-2R} \tag{60}$$

The average reconstruction error in the presence of the two streams is thus.

$$E_{MDCN,2} = E_{MDCN,q,m} = \left(\prod \sigma^2_m\right)^{\frac{2}{N}} 2^{-2R} \tag{61}$$

Extending the results obtained for the two variables case, the estimation error for $A_M$ from $C_m$ is

$$E_{e,a,c,m} = E_{e,min} + \gamma^2_{ca} E_{MDC2,q,m} \tag{62}$$

Similarly,

$$E_{e,b,c,m} = E_{e,min} + \gamma^2_{cb} E_{MDC2,q,m} \tag{63}$$

$$E_{e,a,d,m} = E_{e,min} + \gamma^2_{da} E_{MDC2,q,m} \tag{64}$$

$$E_{e,b,d,m} = E_{e,min} + \gamma^2_{db} E_{MDC2,q,m} \tag{65}$$

The average reconstruction error per for the $m$-th pair in the presence of either stream is:

$$E_{MDCN,1,m} = \frac{1}{2}\left(E_{e,a,c,m} + E_{e,b,c,m}\right) + \frac{1}{2}\left(E_{e,a,d,m} + E_{e,b,d,m}\right) \tag{66}$$

$$= 2E_{e,min} + \frac{1}{2}\left(\gamma_{ca}^2 + \gamma_{cb}^2 + \gamma_{da} + \gamma_{db}\right)E_{MDC2,q,m} \tag{68}$$

$$= \frac{2\sigma_{n(m,1)}^2 \sigma_{n(m,2)}^2}{\sigma_{n(m,1)}^2 + \sigma_{n(m,2)}^2} + \frac{2\left(\sigma_{n(m,1)}^4 + \sigma_{n(m,2)}^4\right)}{\left(\sigma_{r(m,1)}^2 + \sigma_{n(m,2)}^2\right)^2}\left(\prod \sigma_m^2\right)^{\frac{2}{N}} 2^{-2R} \tag{67}$$

The average reconstruction error per symbol in the presence of one stream is:

$$E_{MDCN,1} = \frac{1}{N}\sum_{m=1}^{N/2} E_{MDCN,1,m} \approx \frac{2}{N}\sum_{m=1}^{N/2} \sigma_{n(m,1)}^2 \frac{\sigma_{n(m,2)}^2}{\sigma_{n(m,1)}^2 + \sigma_{n(m,2)}^2} \tag{69}$$

The reconstruction error when both streams are lost is:

$$M_{MDCN,0} = \frac{1}{N}\sum_{n=1}^{N} \sigma_n^2 \tag{70}$$

The average error for channel loss rates $p_0$, $p_1$ and $p_2$ is:

$$E_{MDCN} = p_2 E_{MDCN,2} + p_1 E_{MDCN,1} + p_0 E_{MDCN,0} \tag{71}$$

**Comparison of SDCN and MDCN**

Comparing (51) and (61), we get:

$$\frac{E_{MDCN,2}}{E_{SDCN,2}} = \left(\prod_{m=1}^{N/2} r_m\right)^{2/N} = r \tag{72}$$

where

$$r_m = \frac{\sigma_{n(m,1)}^2 + \sigma_{n(m,2)}^2}{2\sqrt{\sigma_{n(m,1)}^2 \sigma_{n(m,2)}^2}} \tag{73}$$

is the flatness measure of the m-th pair, and $r$ is the geometric mean of the flatness measures of the $N/2$ pairs.
To compare the reconstruction error in the presence of one stream only, we again neglect the quantization error since it is small compared to the estimation error. Then

$$\frac{E_{SDCN,1}}{E_{MDCN,1}} = \frac{\frac{1}{2}\sum_{n=1}^{N}\sigma_{n}^{2}}{\sum_{m=1}^{N/2}\frac{2\sigma_{n(m,1)}^{2}\sigma_{n(m,2)}^{2}}{\sigma_{n(m,1)}^{2} + \sigma_{n(m,2)}^{2}}} \qquad (74)$$

$$= \frac{\sum_{m} r_{m}\sqrt{\sigma_{n(m,1)}^{2}\sigma_{n(m,2)}^{2}}}{\sum_{m}\frac{1}{r_{m}}\sqrt{\sigma_{n(m,1)}^{2}\sigma_{n(m,2)}^{2}}} \qquad (75)$$

Next, let us consider the bit rate increase incurred by the MDCN if we require that the average quantization error to be equal to a preset threshold, $E_q$. This is a bit allocation problem where we want to minimize the total number of bits subject to a constraint on the total quantization error. The optimal solution for the SDCN is:

$$R_{SDCN,n} = \frac{1}{2}\log_2\frac{\sigma_n^2}{E_q}, \ n = 1, 2, ..., N, \qquad (76)$$

and the average bit rate is

$$R_{SDCN} = \frac{1}{N}\sum_{n} R_{SDCN,n} = \frac{1}{2}\log_2\frac{\left(\prod \sigma_m^2\right)^{\frac{1}{N}}}{E_q} \qquad (77)$$

With MDCN, the above result should be applied to each stream of $N/2$ samples, and the results are:

$$R_{MDCN,m} = \frac{1}{2}\log_2\frac{\sigma_m^2}{E_q}, \ m = 1, 2, ..., N/2 \qquad (78)$$

$$R_{MDCN} = \frac{2}{N}\sum_{m} R_{MDCN,m} = \frac{1}{2}\log_2\frac{\left(\prod \sigma_m^2\right)^{2/N}}{E_q} \qquad (79)$$

Therefore, the average bit rate increase is

$$\Delta R_N = R_{MDCN} - R_{SDCN} = \frac{1}{2}\log_2\left(\prod r_m\right)^{2/N} = \frac{1}{2}\log_2 r \qquad (80)$$

## Pairing Schemes

We now consider what is the best pairing scheme so that the overall reconstruction error described in (71) is minimized for a given channel error rate $p$ and a prescribed bit rate $R$. An analytical solution to this optimization problem is difficult to find. However, because there are only finite number of possible pairing options, $N(N-1)/2$, it is possible to use an integer programming method to find the best combination so that the above error is minimized.

Recall that in order to reduce the estimation error in the presence of one stream, one should pair symbols which differ significantly in variance. On the other hand, to increase the coding efficiency (reduce the quantization error for a given bit rate, or reduce the bit rate for a given quantization error), one should pair two symbols with similar variances. Minimization of the total reconstruction error in (71) is essentially a balancing act, weighted by the channel loss rate.

For more reliable communications, one may require that the estimation error in the presence of one stream be less than a preset threshold, regardless of how small the channel loss rate is. In the following, we describe an algorithm which will partition $N$ symbols into $N/2$ pairs so that the estimation error per symbol is less than or equal to a preset value, $E_e$, and in the mean time, the loss in the coding efficiency is minimized.

To see how this can be accomplished, we first introduce another Lemma. Lemma 2:

Given one RV $A$, with variance $\sigma_a^2$, for the estimation error to be less than or equal to $E_e$ (assuming $E \leq \sigma_a^2$), it must be paired with a RV $B$ with variance

$$\sigma_b^2 \leq \sigma_{b,min}^2 = \frac{\sigma_a^2}{\sigma_a^2 - E_e} E_e, \text{ or } \lambda = \frac{\sigma_b^2}{\sigma_a^2} \leq \frac{E_e}{\sigma_a^2 - E_e} \qquad (81)$$

It can be shown that if $\sigma_a^2 > 2E_e$, then $E_e < \sigma_b^2 < 2E_e$. The reverse is also true.

The above Lemma is easily derived by requiring the $E_{e,min}$ in (4) to be $\leq E_e$.

**Pairing Algorithm A**: Recall that, for a given $\sigma_a^2$, the smaller is $\sigma_b^2$, the more loss in coding efficiency would occur. Therefore the best $\sigma_b^2$ is the largest one that satisfies the constraint in (81). Based on this criterion, we derive the following pairing algorithm which, for each pair to be chosen, minimizes the loss in coding efficiency, while satisfying the constraint on the estimation error.

**Step 1** *Order the $X_n$ so that $\sigma_1^2 \geq \sigma_2^2 \geq ... \sigma_N^2$. Put them in a stack so the $X_1$ is at the top. Set $m = 1$.*

**Step 2** *Select $A_m$ from the top element in the stack, and delete it from the list.*

**Step 3**. *If the stack is not empty, choose $B_m$ from the remaining ones in the stack so that its variance is the largest one satisfying*

$$\sigma_b^2 \leq \frac{\sigma_a^2 E_e}{\sigma_a^2 - E_e} \qquad (82)$$

*If such an element is found, delete it from the list, and go to Step 4. Otherwise, if such an element does not exist or if the stack is already empty, set $B_m$ to zero.*

**Step 4** *If the stack is not empty, set $m = m + 1$, go to Step 2.*

Although the above algorithm can satisfy the constraint on the estimation error strictly, it does waste bits when pairing a symbol with a zero. Essentially, this symbol is coded twice and transmitted in separate channels. One may choose instead to use the bottom element in the current stack, if one can afford to relax the constraint on the estimation error.

Note that the above algorithm does not necessarily minimize the overall loss in coding efficiency over all N symbols. Rather it minimizes the loss in coding efficiency associated with each pair at a time, by taking the pair with the largest possible variance ratio. In this sense, it is a greedy algorithm.

**Pairing Algorithm B:** From (81), it is easy to see that if

$$\sigma_{a,1}^2 > \sigma_{a,2}^2 \tag{83}$$

then

$$\sigma_{b,1,max} < \sigma_{b,2,max} \tag{84}$$

This leads to the second, simpler, pairing algorithms *Order $X_n$ so that $\sigma_1^2 \geq \sigma_2^2 \geq ... \sigma_N^2$. Pair the k-th one with the (N-k)-th one in the list, i.e., $A_m = X_m$, $B_m = X_{N-m+1}$, for m = 1, 2 N/2.*

Note that this algorithm does not guarantee that the estimation error for each symbol is less than a preset value. But it avoids the overhead associated with the first algorithm where some symbols have to be paired with zeros. We have implemented both the Modified Pairing Algorithm A and the Pairing Algorithm B. For several test sets of variances, they have yielded the same pairing results. Therefore, in the actual coder simulation, we have only used the Pairing Algorithm B.

**Implementation of Multiple Description Coding in Transform Coders Proposed Multiple Description Transform Coding (MTC)**

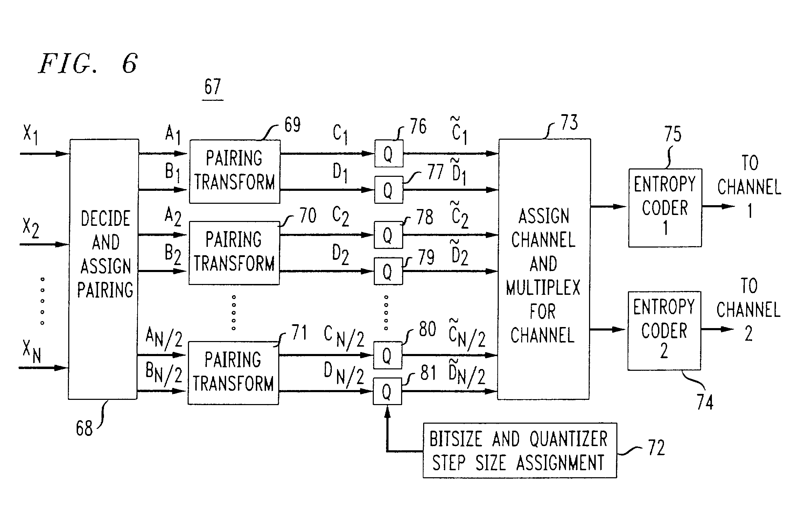

Although the MDCN described in the previous section can be applied to any *N* uncorrelated samples, it is helpful (in terms of reducing the reconstruction error when the transmission channel is not reliable) only if these samples have drastically different variances. As already hinted, the motivation for the proposed MDCN is for increasing the reliability of a communication system utilizing a transform coder. The general structure of the proposed multiple description transform coder (MTC) is illustrated in FIG 6.

In this coder, each block of *L* samples are transformed using a *L-pt* unitary transform. The transformed coefficients are then arranged in a decreasing order based on their variances. Then for a preset value of maximum estimation error $E_e$, which should be larger than the largest quantization error allowed $\sigma_q^2$, we find the first N coefficients with $\sigma_n^2 > E_e$. Then using a pairing algorithm, these *N* coefficients are split into *N/2* pairs, $A_m$, $B_m$, m = 1, 2, ..., N/2. Each pair is transformed using (11) to yield $C_m$, $D_m$. All the $C_m$ are then put sequentially into stream one, while all $D_m$ are put into stream two. For the remaining coefficients, even indexed ones are appended to stream one, and odd indexed coefficients are appended to stream two. Each stream is then quantized and coded independently and transmitted through separate channels.

If both streams are received, then the decoder performs the inverse transform in (15) on each pair of received samples, $\tilde{C}_m$ ,$\tilde{D}_m$ to recover the quantized coefficients $\tilde{A}_m$ , $\tilde{B}_m$ . If only one stream is received, say, the one containing $\tilde{C}_m$ , then based on each $\tilde{C}_m$ , for $1 \leq n \leq N/2$, $\tilde{A}_m$ and $\tilde{B}_m$ are estimated using the linear estimator described in (13). For the remaining coefficients which are split by the even-odd rule, the missing coefficients are simply replaced with their means, which are assumed to be zeros. Finally, all the recovered coefficients are inversely transformed to produce the samples in the original domain.

In the analysis presented in the previous sections, we have assumed each $C_m$ or $D_m$ is uniformly quantized subject to an optimal bit allocation within each stream, which makes the assumption that each quantized index is coded independently. In practice, we can apply the run-length plus Huffman coding method of the JPEG coder to each stream, which has proven to provide significant improvement over independent coding of individual coefficients. Our implementation is based on the JPEG method which uses the $L = 8 \times 8 = 64$ point two dimensional Discrete Cosine Transform (DCT) as the unitary transform. The DCT coefficients are first scaled using a perception-based normalization matrix (we used one recommended in the JPEG standard). It is these scaled coefficients which are separated (by pairing and splitting) to two streams. The coefficients in each stream are uniformly quantized using the same quantization interval. The quantized coefficients are then coded using a combination of the run-length and Huffman coding, in exactly the same way as in the JPEG coder. The difference is that there are only $L/2 = 32$ coefficients in each stream is treated as the DC component.

A difficulty in applying the above coder to real images is that they are not statistically stationary. The statistical properties vary significantly among different images, and among different blocks of the same image. Because the linear estimation coefficients need to be determined based on coefficient variances, a mismatch in the actual variances and the assumed ones could lead to large estimation error. We have evaluated two implementations. In the first one (to be referred to as MTC1), the variances of transform coefficients are obtained by averaging over all the blocks in an image. From these calculated variances, the coefficients are ordered and paired using Pairing Algorithm B. The linear estimation coefficients are also determined based on these global statistics. With the second implementation (to be referred to as MTC2), the blocks in each image are classified into several classes so that the transform coefficients of the blocks in the same class have similar statistical properties. Then the coefficient variances of each class are calculated and ordered, so are the linear estimation coefficients. The two coders are discussed in more detail in the following.

### The Basic Version: MTC1

In the basic version, MTC1, for each image, the coder goes through three passes. In the first pass, statistics of the coefficient means and variances are collected, and a coefficient scanning table is produced which orders the coefficients based on their variance values. The estimator coefficients,

$$\gamma_{ca}(m), \gamma_{cb}(m), \gamma_{da}(m), \gamma_{db}(m), \; m = 1, 2, ..., N/2 \tag{85}$$

also determined and stored in a estimator table. Then in the second pass, the coefficients are grouped and quantized, and the statistics for the run-length symbols in each stream are collected. The Huffman tables for coding the DC and AC coefficients are designed based on the collected statistics from each stream. In the final third pass, the coefficients are converted into bit streams using the Huffman tables produced.

### The Enhanced Version with Block Classification: MTC2

The MTC1 assumes that all the blocks in an image have similar statistics. This is rarely true for real images. For example, blocks in a flat regions will have very different DCT coefficient distributions than blocks over a sharp edge in a particular direction. Blocks covering edges in different directions will also have quite distinct characteristics. In order to coop with this non-stationarity within an image itself, the second coder, MTC2, classifies the blocks in each image into several classes so that the transform coefficients of the blocks in the same class have similar statistical properties.

In our present simulation, four classes are considered, which essentially correspond to blocks that are smooth, with horizontal edges, with vertical edges, and the rest. The classification is accomplished by examining the coefficient concentration pattern. If the energy of the DC coefficient exceeds a certain percentage (specified as a threshold) of the total coefficient energy, then the block is classified as smooth; otherwise, if the energy along the first column (or now) of the DCT block exceeds the preset threshold, the block is classified as with horizontal (or vertical) edges. A threshold of 95% has yielded quite good classification results for several test images.

In order to evaluate the loss in coding efficiency of the proposed multiple description coders against a good single description coder, we also implemented a JPEG-like coder, in which all the DCT coefficients in a block are coded together using the run-length plus Huffman coding method. As with the MTC 1 and MTC2, the Huffman coders required in this coder are also optimized for the image being coded. In order to split the resulting bit stream into two symmetric descriptions, we put the bits from even indexed blocks into stream one and those from odd indexed blocks into stream 2. In the decoder, if only one stream (e.g. stream one containing even blocks) is received, the blocks in the missing stream (e.g. the odd blocks) are simply reconstructed by assigning each pixel the mean image value. Obviously, the reconstructed image in the presence of only one stream would be very poor, with a severe checker-board artifact. We realize that some error concealment techniques can be applied to improve the reconstruction quality, which essentially interpolate the missing blocks from surrounding received blocks.

In both the STC and the two MTCs, the DCT coefficients are first scaled by a visual based normalization matrix (we used the one recommended in the JPEG standard). These scaled coefficients or their transformed versions (in the MTC 1 and MTC2 case) are then quantized using the same quantization intervals. In all cases, the Huffman tables required in the coder are designed based on the statistics collected for the image being coded. For the STC, only one set of Huffman tables needs to be designed; for MTC 1, two sets of tables are designed, one for each description; finally for MTC2, eight sets of tables are designed, one for each class and description. Because these tables are image dependent, they need to be coded as side information. In addition, with the MTC 1, one set of the coefficient ordering vector and the estimation coefficients also need to be specified, whereas MTC2, four sets of such side information are to be specified. In practice, one should be able to pre-design necessary Huffman tables as well as the coefficient ordering table and estimation coefficients (for the MTC1 and MTC2 case) based on a good collection of training images. The bit rate increase from that using image dependent tables should not be very significant, and should be similar for all the coders. In fact, we have evaluated the effect of using the same Huffman tables for two descriptions in the MTC coders. The increase in bit rate is very insignificant. For the MTC2, we do add 2 bits per block which is required for specifying the class index of the block.

**Summary and Discussion**

**Proof of Lemma 1 and Theorem 1**

**Proof of Lemma 1.** We first consider the estimation of $A$ from $C$. Let $\hat{A} = \gamma_a C$. We need to determine $\gamma_a$ so that the estimation error

$$E_{e,a} = E\{(A - \hat{A})^2\} = E\{(A - \gamma_{aC})^2\} \qquad (86)$$

is minimized. By the orthogonality principle, we obtain

$$E\{(A - \gamma_a C)C\} = 0 \text{ or } E\{AC\} = \gamma_a E\{C^2\} \qquad (87)$$

Because $E\{AB\} = 0$, we get

$$\gamma_a = \frac{\alpha\sigma_a^2}{\alpha^2\sigma_a^2 + \beta^2\sigma_b^2} \qquad (88)$$

$$E_{e,a,min} = \frac{\beta^2\sigma_a^2\sigma_b^2}{\alpha^2\sigma_a^2 + \beta^2\sigma_b^2} \qquad (89)$$

Similarly, let B, we will find

$$\gamma_b = \frac{\beta\sigma_b^2}{\alpha^2\sigma_a^2 + \beta^2\sigma_b^2} \qquad (90)$$

$$E_{e,b,min} = frac\,\alpha^2\sigma_a^2\sigma_b^2\alpha^2\sigma_a^2 + \beta^2\sigma_b^2 \qquad (91)$$

**Proof of Theorem 1.** First let us consider the following problems: Find $\alpha$ and $\beta$ so that if $C = \alpha A + \beta B$ is available for estimating $A$ and $B$, the estimation errors for $A$ and $B$ are the same and this error is minimized. From Lemma 1, this is easily accomplished by requiring

$$E_{e,a,min} = E_{e,b,min} \qquad (92)$$

This yields:

$$\beta = \pm\alpha$$

$$E_{e,min} = E_{e,a,min} = E_{e,b,min} = \frac{\sigma_a^2\sigma_b^2}{\sigma_a^2 + \sigma_b^2}$$

$$\gamma_a = \frac{\sigma_a^2}{\alpha(\sigma_a^2 + \sigma_b^2)}, \quad \gamma_b = \pm\gamma_a \qquad (93)$$

Now let us consider how to construct a pair of transforms to satisfy the requirement of Theorem 1. From the above result, one transform can be obtained by letting $\beta = \alpha$, and the other transform can be constructed by letting $\beta = -\alpha$. Any value of $\alpha$ will satisfy the equal estimation error criterion. However, to satisfy the energy preserving requirement, we must set

$$\alpha = \frac{1}{\sqrt{2}} \qquad (94)$$

This leads to the transform given in Theorem 1.

The linear predictors and minimal prediction errors given in Theorem 1 can be easily obtained from those given in Lemma 1 by setting

$$\alpha = \frac{1}{\sqrt{2}} \qquad (95)$$

$$\beta = \pm \frac{1}{\sqrt{2}} \qquad (96)$$

**Two-Sample Multiple Description Encoder**

FIG 2 depicts a two-sample multiple description encoder 20 according to the present invention. The samples A and B are the resulting original samples that may have been transformed using a known Discrete Cosine Transform (not shown), but they need not have been first transformed.

As discussed above, the present invention transforms the input variables and then separately quantizes and entropy encodes the transformed variables using known quantizers and entropy encoders. The resulting bits are then transmitted over separate channels.

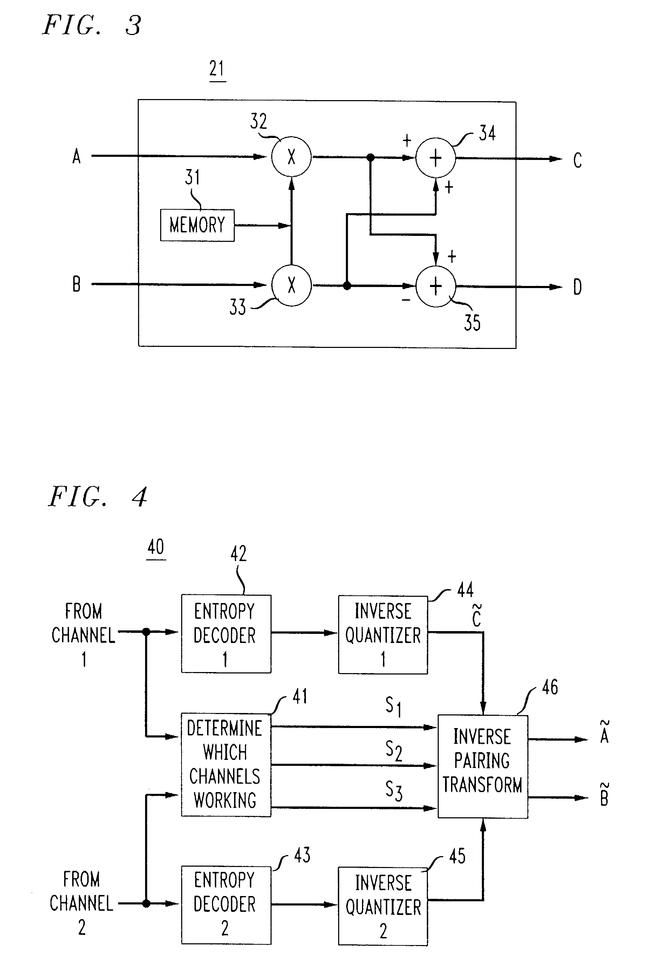

Referring to FIG 2, samples A and B enter the Pairing Transform 21, which outputs samples C and D. The details of the pairing transform 21 will be discussed later with reference to FIG 3. The pairing transform outputs are then quantized by quantizers 22, 23, respectively, using the same quantization step size to produce samples $\tilde{C}$ and $\tilde{D}$, which are individually entropy coded using standard entropy coders 24, 25, respectively. The entropy-coded sample $\tilde{C}$ is sent on channel 1 while the entropy-coded sample $\tilde{D}$ is sent on channel 2. In an alternate embodiment, the quantization in quantizers 22 and 23 can be offset as discussed earlier, if desired.

The circuit diagram depicted in FIG 2 can be implemented in discrete logic or in software, as is known in the art. The quantizers 22, 23 and entropy encoders 24, 25 are well-known in the art, and need not be described further.

**Pairing Transform**

FIG 3 depicts the pairing transform used in the present invention. In the pairing transform 21, samples A and B are input to standard multipliers 32, 33, respectively, and are multiplied by the value stored in the memory storage location 31, which has been initialized at the value $1/\sqrt{2}$. To produce the output C, the outputs of the multipliers 32, 33 are input to adders 34, 35, respectively, and are added. Similarly, to produce the output D, the output of the multiplier 33 is subtracted from the output of the multiplier 34 in adder 35. Thus, the output of adder 34 is the transformed variable C, whereas the output of adder 35 is the transformed variable D.

The circuit diagram depicted in FIG 3 can be implemented in discrete logic or in software, as is known in the art. The multipliers 32, 33 memory 31, and adders 34, 35 are well-known in the art, and need not be described further.

**Two-Sample Multiple Description Decoder**

FIG 4 depicts a Two-Sample Multiple Description Decoder 40 according to the present invention. The decoder 40 is for use with the Two-Variable Multiple Description Encoder 20 depicted in FIG 2.

First, the block "Determine which channels working" 41 determines whether channel 1, channel 2, or both are working by monitoring their inputs to the decoder 40. One possible embodiment for performing this function is to monitor the channel for the incoming error rate. For example, the device monitors the incoming bit stream to determine if the error rate is in excess of a predetermined value, for example, to make the decision whether the input is working or not. If the error exceeds the predetermined threshold, then the device determines that the input is not working and sets the switches as described below. If the error is within the predetermined threshold, then the device determines that the input is working and sets the switches as described below. Alternate embodiments for performing this function are well-known in the art, and could easily be implemented by one of skill in the art.

Referring to FIG 4, the inputs from each channel are entropy decoded using standard entropy decoders 42, 43. The outputs of the entropy decoders 42, 43 are inverse quantized by standard inverse quantizers 44, 45, respectively, to obtain samples $\tilde{C}$ and $\tilde{D}$. These samples $\tilde{C}$ and $\tilde{D}$ then enter the Inverse Pairing Transform (IPT) 46, which produces outputs $\tilde{A}$ and $\tilde{B}$. The Inverse Pairing Transform also receives as inputs the values of the three switches S1, S2, and S3, from the block "Determine which channels working" 41.

The circuit shown in FIG 4 can be implemented in discrete logic or software, as is well-known in the art.

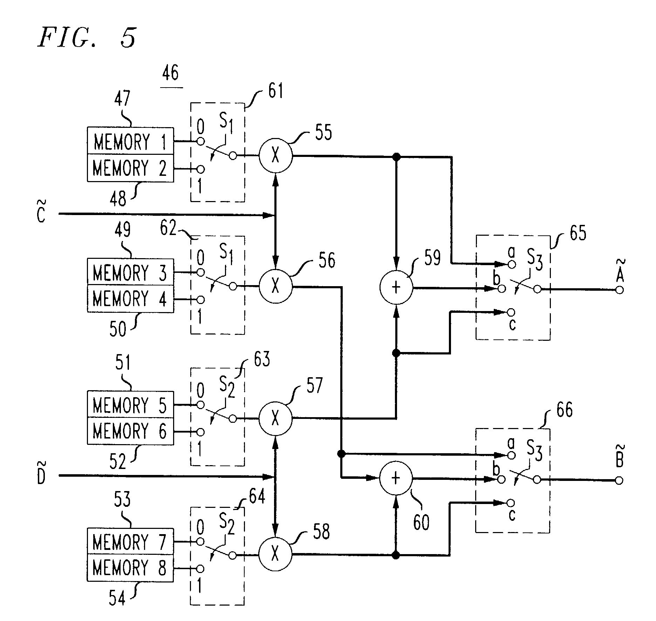

As shown in FIG 5, the Inverse Pairing Transform 46 contains eight standard memory locations 47-54, six standard switches 61-66, two standard adders 59, 60, and four standard multipliers 55-58. Switches S1, S2, and S3 are set according to the determination, as indicated in Table 1. If both inputs are received ( $\tilde{C}$ and $\tilde{D}$ ), the switch $S_1 = 1$, $S_2 = 1$, and $S_3 = b$. On the other hand, if only one input is received, then the switch corresponding to that input is set to zero, i.e., if only $\tilde{C}$ is received then $S_1 = 0$ and $S_3 = a$, and if only $\tilde{D}$ is received then $S_2 = 0$ and $S_3 = c$.

|  | $S_1$ | $S_2$ | $S_3$ |
|---|---|---|---|
| $\tilde{C}$ and $\tilde{D}$ | 1 | 1 | b |
| $\tilde{C}$ only | 0 | - | a |
| $\tilde{D}$ only | - | 0 | c |

| The eight memory locations 47-54 are initialized at the values shown in Table 2 | |
|---|---|
| Memory Location | Value Stored in Memory Location |
| 1 | $\dfrac{\sqrt{2}\sigma_a^2}{(\sigma_a^2 + \sigma_b^2)}$  (97) |
| 2 | $\dfrac{1}{\sqrt{2}}$  (98) |
| 3 | $\dfrac{\sqrt{2}\sigma_b^2}{(\sigma_a^2 + \sigma_b^2)}$  (99) |
| 4 | $\dfrac{1}{\sqrt{2}}$  (100) |
| 5 | $\dfrac{\sqrt{2}\sigma_a^2}{(\sigma_a^2 + \sigma_b^2)}$  (101) |
| 6 | $\dfrac{1}{\sqrt{2}}$  (102) |

(continued)

| Memory Location | Value Stored in Memory Location |
|---|---|
| 7 | $\dfrac{\sqrt{2}\sigma_b^2}{(\sigma_a^2 + \sigma_b^2)}$    (103) |
| 8 | $-\dfrac{1}{\sqrt{2}}$    (104) |

Depending on the position of switches $S_1$ (either 0 or 1) (switch $S_1$ is shown as elements 61-62 for simplicity), the value $\check{C}$ is multiplied by both the values in memory location 1 or 2 (elements 47-48) and memory location 3 or 4 (elements 49-50). Similarly, depending on the position of switch $S_2$ (either 0 or 1) (switch S2 is shown as elements 63-64 for simplicity), the value $\check{D}$ is multiplied by both the values in memory location 5 or 6 (elements 51-52) and memory location 7 or 8 (elements 53-54).

The outputs of multipliers 55 and 57 are added, as are the outputs of multipliers 56 and 58, to become the values $\check{A}$ and $\check{B}$, respectively, when switch $S_3$ (shown as elements 65-66 for simplicity) is in position "b." When switch $S_3$ is in position "a," $\check{A}$ is the output of multiplier 55 and $\check{B}$ is the output of multiplier 56. When switch $S_3$ is in position "c," $\check{A}$ is the output of multiplier 57 and $\check{B}$ is the output of multiplier 58.

The circuit depicted in FIG 5 can be implemented in discrete logic or software, as is well known in the art.

**N-Sample Multiple Description Encoder**

FIG 6 shows the N-sample multiple description encoder 67 of the present invention. Essentially, the N-Sample version of the present invention employs the Two-Sample Multiple Description Encoder 20 as building blocks. Three additional blocks are necessary. First, the decide and assign pairing block 68 converts the incoming samples to paired samples, which can then be processed by N/2 Two-Sample MDCs 20, each of which consists of a pairing transform (69, 70, or 71) and two quantizers (76, 77 or 78, 79 or 80, 81, respectively).

$$E = \frac{q_m^2}{12} \tag{105}$$

where $q_m$ is the quantizer step size to quantize pair m. Thus, to maintain the error the same, each quantizer may have a potentially different quantizing size.

Second, the Assign Channel and Multiplex for Channel block 73 receives the outputs from all of the MDCs and assigns channels and multiplexes them into a format suitable for the channels. Finally, the bit size and step size assignment 72 controls the quantization level of the quantizers. Note that

Returning to the input, the N samples $X_1$ through $X_N$ are input to the block "Decide and Assign Pairing" 68, which outputs the samples by pairs as described below. For convenience, we rename the paired samples as $A_1$ and $B_1$, $A_2$ and $B_2$, ..., $A_{N/2}$ and $B_{N/2}$. The N/2 pairs are input to the N/2 Pairing Transforms 69-71 to output $C_1$ and $D_1$, $C_2$ and D2, ..., and $C_{N/2}$ and $D_{N/2}$. Each of the Pairing Transforms is as depicted in FIG 3 and described above.

Each member of the pair $C_i$ and $D_i$ are quantized by quantizer $Q_i$ (76-81) with a step size determined from the "Bit Allocation and Quantizer Step size Assignment" block 72. In "Assign channel and Multiplex for Channel" 73 samples $C_1$, $C_2$, ... and $C_{N/2}$ are assigned and multiplexed for channel 1 while samples $D_1$, $D_2$, ... and $D_{N/2}$ are assigned and multiplexed for channel 2. These multiplexed samples are then entropy coded using a standard entropy coder 74, 75 typical in image compression systems. The outputs of the entropy coders 74, 75 are then sent on their respective channels.

**Determine Pairing Assignment A**

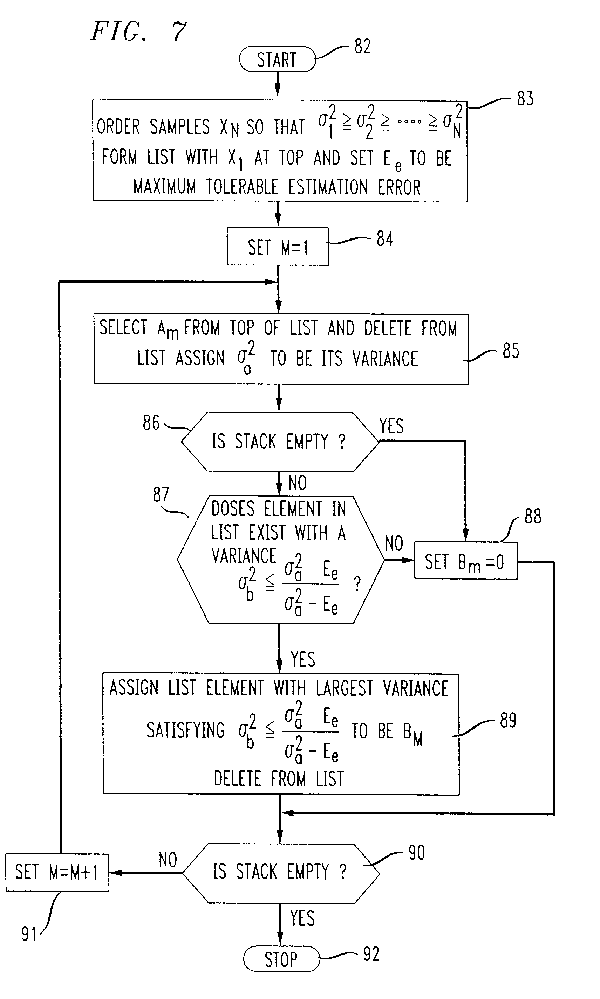

The algorithm for determining the pairing assignment A according to the present invention is depicted in FIG 7. First, the samples $X_N$ are ordered according to their variance $\sigma^2$, such that $\sigma_1^2 \geq \sigma_2^2 \geq \cdots \geq \sigma_N^2$. The list is formed with the sample ($X_1$) with the largest variance at the top. The maximum tolerable estimation error $E_e$ is preset, which is a value that can be selected by one of skill in the art.

The incremental counter is set to one, and the first sample is selected from the top of the list and set equal to $A_m$.

The first sample is then deleted from the list. Its variance is set to $\sigma_a^2$. Next, the stack is examined to determine if all of the samples have been assigned. If so, i.e., YES, then $B_m$ is set to zero, and flow returns to "Is stack empty" 90. If the stack is not empty, i.e., NO from element 86, then the list is examined to determine if there is a element in the list with a variance such that:

$$\sigma_b^2 \leq \frac{\sigma_a^2 E_e}{\sigma_a^2 - E_e} \tag{106}$$

If YES, then that element is assigned to be $B_m$ and is then deleted from the list. If the answer from element 87 is NO, then $B_m$ is set to zero, and flow returns to "Is stack empty" 90. The stack is then examined to determine if it is empty (element 90), and if the answer is YES, flow ends. If the answer is NO, the counter is incremented and flow returns to element 85.

**Determine Pairing Assignment B**

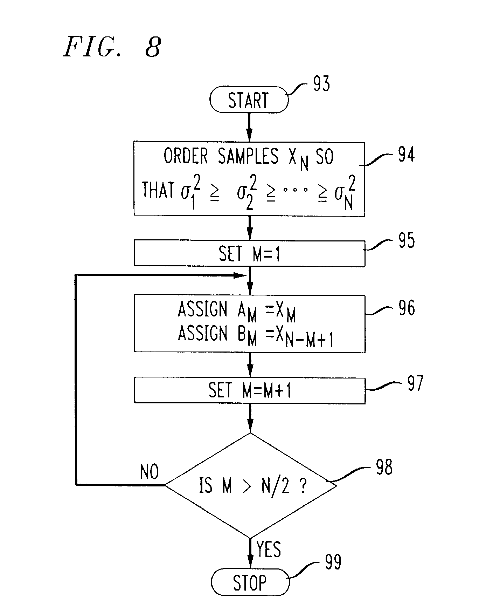

FIG 8 depicts the pairing assignment B used in the present invention. First, the samples are ordered as in pairing assignment A, with the largest variances first. The incremental counter is set to one. The variables are then paired largest with smallest, moving towards the middle so that the middle two variables are paired together. First, the sample with the largest variance ($X_1$) is set to $A_1$, while the sample with the smallest variance ($X_N$) is set to $B_1$ and the two variables $A_1$ and $B_1$ are paired. Similarly, the next samples with the largest ($X_2$) and smallest ($X_{N-1}$) variances, respectively, are paired. The process continues until the middle two samples are paired (element 98), e.g., $X_{N/2}$ and $X_{N/2+1}$.

**N-Sample Multiple Description Decoder**

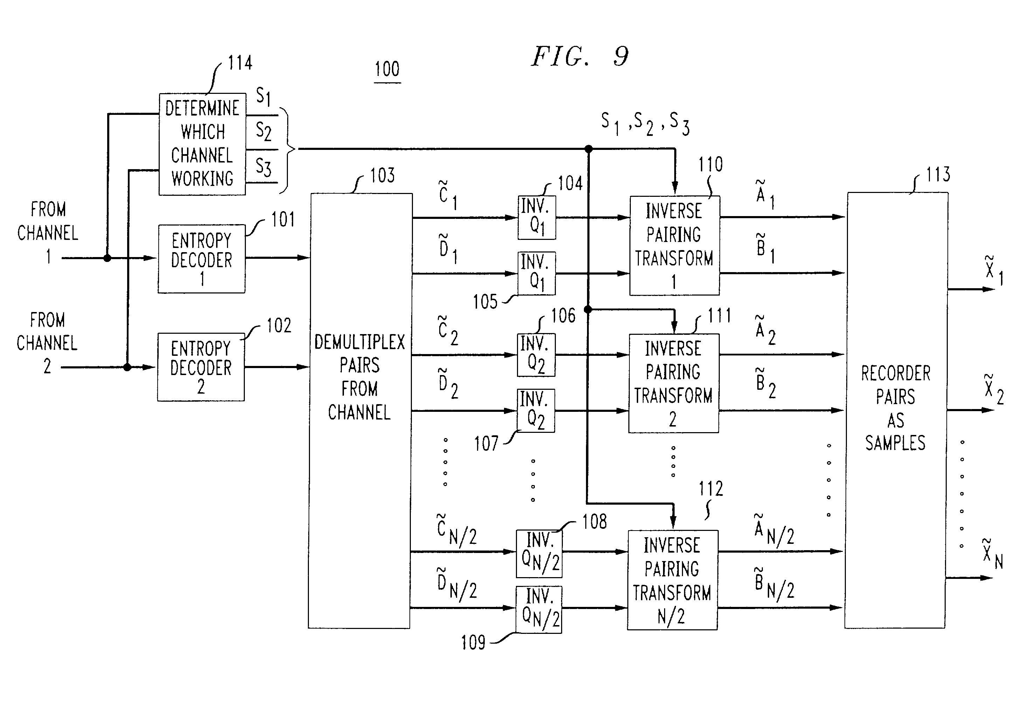

FIG 9 depicts the N-Sample Multiple Description Decoder 100 according to the present invention. Similar to the N-Sample Encoder 67, which used the Two-Sample Encoder 20 as building blocks, the N-Sample Decoder 100 uses the Two-Sample Decoder 40 as building blocks. The Inverse Pairing Transforms 110-112 are as described in the Two-Sample Decoder 40 (FIG 4), as are the inverse quantizers 104-109, the "Determine which channels working" block 114, and the entropy decoders 101-102. The only additional blocks are the "Demultiplex pairs from channel" block 103 and the "Reorder pairs as samples" block 113.

As in the 2-sample multiple description decoder 40 (FIG 4), the block "Determine which channels working" 100 determines whether channel 1, channel 2, or both are working by monitoring their inputs to the decoder 100. Switches S1, S2, and S3 are set as before, in Table 1. The inputs from the channel are entropy decoded, using standard entropy decoders 101, 102. The outputs of the entropy decoders 101, 102 are demultiplexed into pairs in "Demultiplex pairs from channel" 103. Each member of each pair is inverse quantized using standard inverse quantizers 104-109. The pairs then enter their Inverse Pairing Transforms 110-112, which operate as described in FIG 5, using the switch positions generated from the "Determine which channels working" block 114. The outputs of the Inverse Pairing Transforms 110-112 are finally reordered as were the original samples in block 113.

**Multiple Description Image Encoder**

Next, we discuss application of the present invention to the field of image coding. Image coding presents unique problems for encoding algorithms based on statistics. Since all blocks in an image do not have the same statistical characteristics, it is useful to apply the same algorithm using different parameters to different parts of the image. For example, it is useful to classify different blocks in the image as having certain statisical characteristics and then to process each block using parameters that are tailored to its class of blocks. Since the decoding of each block then depends heavily on knowing the correct parameters to use for each class of blocks, that information should be sent on both channels. Furthermore, recognizing that sometimes simply pairing coefficients using the pairing transform may not provide sufficient redundancy, it may also be useful to duplicate the most important coefficients in both channels.

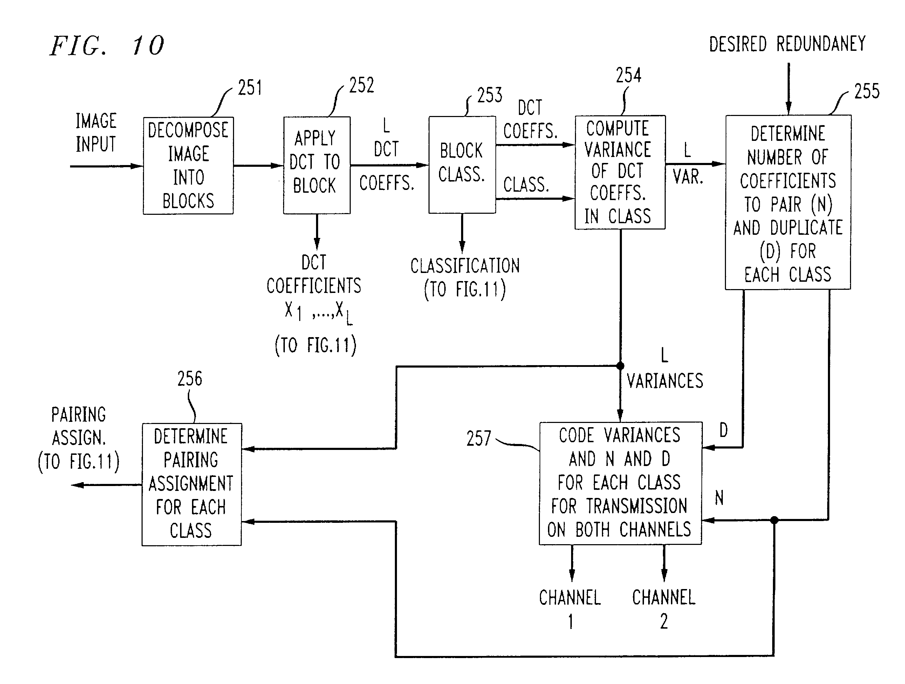

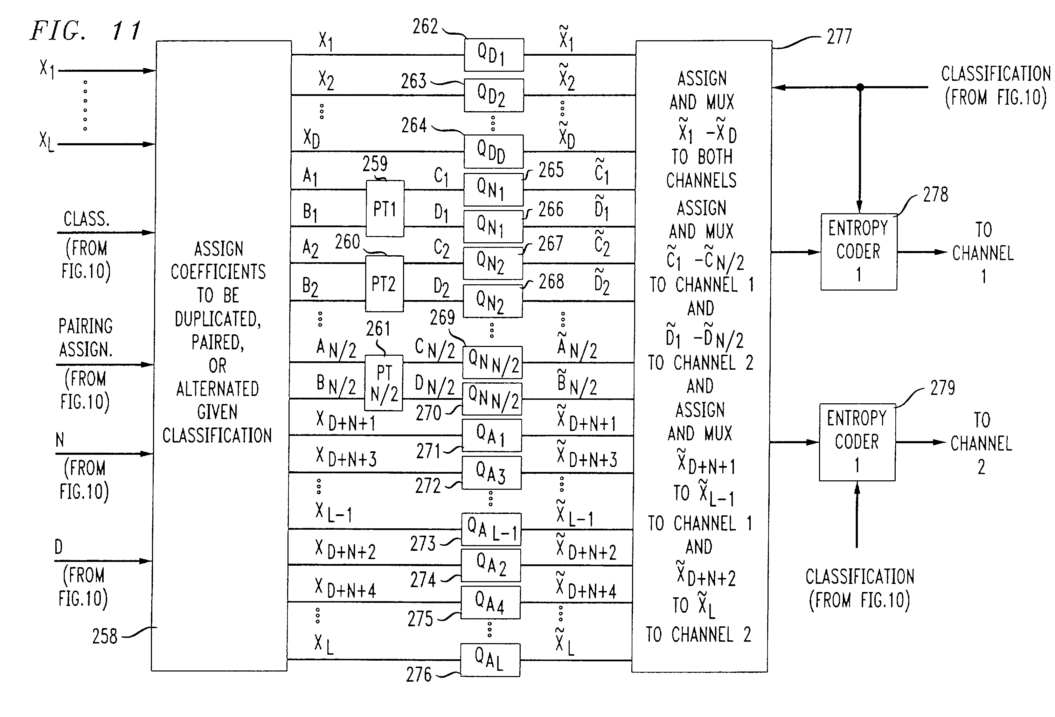

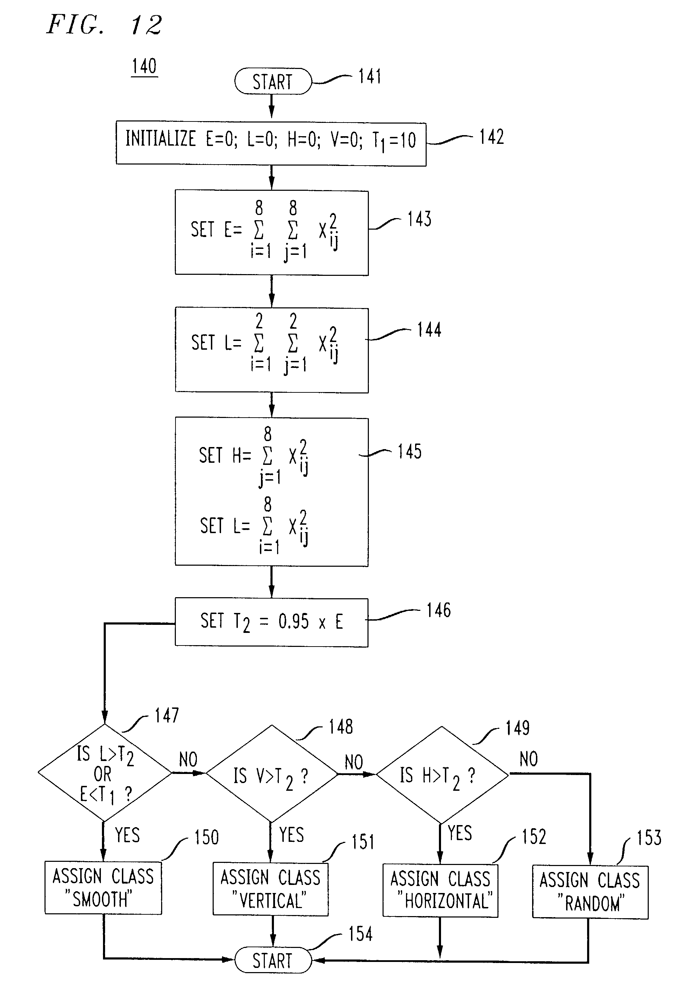

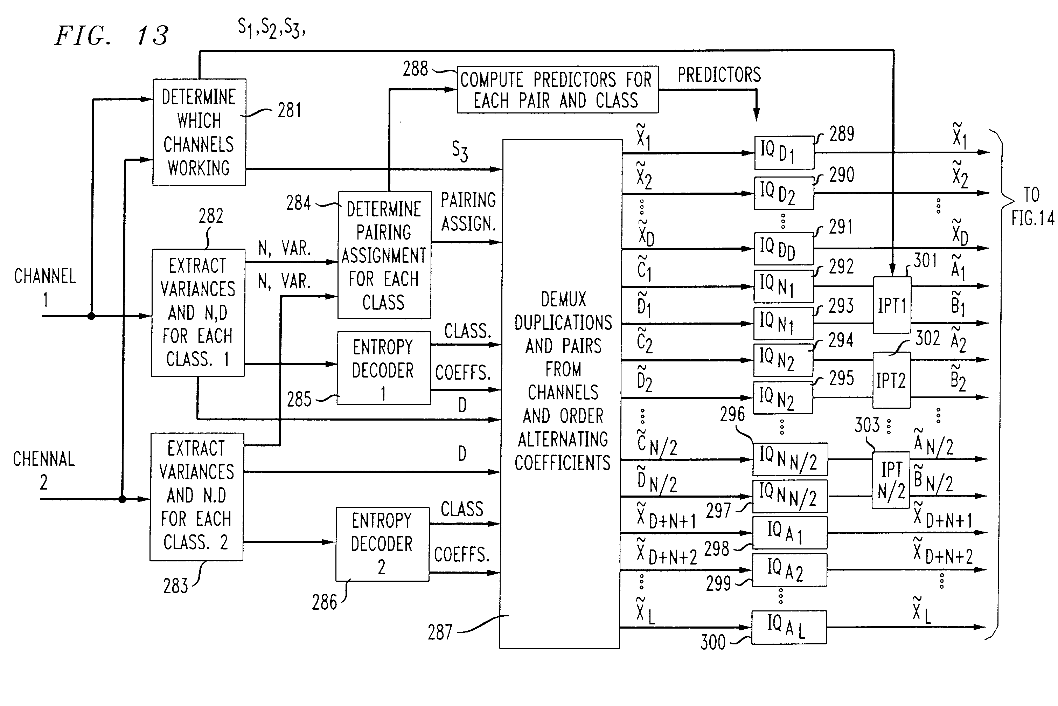

The multiple description image encoder works with two passes. As shown in FIG 10, the image is input into the "Decompose into blocks" element 251, and passed through a Discrete Cosine Transform 252, which outputs the L DCT coefficients to the block classification 253. The operation of the block classification will be described with reference to FIG 12 below.

The block classification 253 outputs the L DCT coefficients and the classifications to the "Compute variance of DCT coefficients in class" 254, as well as to the "Assign Coefficients to be Duplicated, Paired or Alternated" element 258 in FIG 11.

Based on the desired redundancy and the L variances output by the "Compute variances for each class" element 254, the "Determine Number of Coefficients to Pair (N) and Duplicate (D) for each class" element 255 outputs the values N and D, which represent the number of elements to pair and duplicate, respectively.

The "Code Variances and N and D for each class" element 257 then outputs the classification and the values N and D to both channels, as shown in FIG 10.

The "Determine Pairing assignment for each class" element 256 takes for each class the L variances and the value N and pairs N of the coefficients $X_1$ to $X_L$. The remaining are either duplicated or alternated. The number of alternated coefficients is $A = L- D- N$. The pairing assignment is then sent to the "Assign Coefficients ..." element 258 in FIG 11.

The "Assign Coefficients to be Duplicated, Paired or Alternated" element 258 identifies the coefficients to be duplicated and outputs these ($X_1 ... X_D$) for transmission on both channels. Thus, there are D coefficients to be duplicated. These coefficients represent those coefficients that carry the most information (i.e., the highest energy) and cannot be lost over either channel.

The "Assign Coefficients" element 258 also identifies the coefficients to be paired, and outputs these as paired samples ($A_1$, $B_1$, ... $A_{N/2}$, $B_{N/2}$) to be transmitted on different channels. Thus, there are N samples that are transmitted over two channels, hence N/2 samples are transmitted on each channel. These coefficients represent the coefficients that need not be sent over both channels, but cannot be sent in an alternating manner without significant loss in signal quality or information.

Finally, the "Assign Coefficients" element 258 outputs the coefficients to be alternated, which consists of the remaining coefficients, i.e., $A = L - D - N$ coefficients remain to be transmitted. As these coefficients represent the least significant coefficients, i.e., they have the lowest energy, these coefficients can be transmitted in an alternating manner. If any coefficients get lost, they can be replaced with zeros, without significant loss in signal quality or information.

The paired coefficients $A_1$, $B_1$ ... $A_{N/2}$, $B_{N/2}$ are passed through pairing transforms 259-261 as described with reference to FIG 3.

The outputs from the "Assign Coefficients" 258 are then quantized in standard quantizers 262-264 and 271-276 and the outputs from the pairing transforms 259-261 are quantized in standard quantizers 2660-270. The outputs from the quantizers 262-276 are then passed to the "Assign and Mux $\tilde{X}_1$ -$\tilde{X}_D$ to both channels, Assign and Mux $\tilde{C}_1$ -$\tilde{C}_{N/2}$ to Channel 1, and $\tilde{D}_1$ -$\tilde{D}_{N/2}$ to Channel 2, and Assign and Mux $\tilde{X}_{D+N+1}$ -$\tilde{X}_{L-1}$ to channel 1 and $\tilde{X}_{D+N+2}$ -$\tilde{X}_L$ to channel 2" 277. The multiplexer 277 duplicates the $\tilde{X}_1$ -$\tilde{X}_D$ and outputs $\tilde{X}_1$ -$\tilde{X}_D$ to each entropy encoder 278, 279. The multiplexer 277 also outputs the paired samples $\tilde{C}_1$ -$\tilde{C}_N$ to entropy encoder 1 (278), and $\tilde{D}_1$ -$\tilde{D}_N$ to entropy encoder 2 (279), so that these are sent over different channels. Finally, the multiplexer 277 sends the samples $\tilde{X}_{D+N+1}$ -$\tilde{X}_L$ with odd indices to entropy encoder 1 (278), and the samples $\tilde{X}_{D+N-1}$ -$\tilde{X}_L$ with even indices to entropy encoder (279).

The entropy encoders 278, 279 are standard entropy encoders, which output the coded samples to channels 1 and 2, respectively. The classification information is sent on both entropy encoders 278, 279.

**Block Classification**

FIG 12 depicts the block classification algorithm used in the present invention. First, the values E, L, H, and V are initialized to zero, and the threshold $T_1$ is initialized to 10. This could have been a different value, and is used for illustration purposes only. E represents the overall energy of the block. L represents the low energy of the block. H represents the horizontal energy of the block. V represents the vertical energy of the block.

Then, the overall energy in the block, E, is computed as shown in element 143 and as in (107).

$$E = \sum_{i=1}^{8} \sum_{j=1}^{8} X_{ij} \qquad (107)$$

Next, a measure of the low-frequency energy in the block, L, is computed as given in element 144 and as in (108).

$$L = \sum_{i=1}^{2} \sum_{j=1}^{2} X_{ij}^2 \qquad (108)$$

Then, a measure of the horizontal energy, H, and the vertical energy V are computed as in element 145 and (109 and 110).

$$H = \sum_{j=1}^{8} X_{ij}^{2} \qquad\qquad (109)$$

$$V = \sum_{i=1}^{8} X_{ij}^{2} \qquad\qquad (110)$$

In the next step 146, threshold $T_2$ is set to be 95% of the overall energy in the block: $T_2 = 0.95\ {}^{*}E$. Then, it is tested whether $L > T_2$ or $E < T_1$. If YES, the block is assigned to the class "SMOOTH." If NO, the block is further tested whether $V > T_2$. If YES, the block is assigned to the class "VERTICAL," IfNO, the block is again further tested whether $H > T_2$. If YES, the block is assigned to the class "HORIZONTAL." If NO, the block is assigned to the class "RANDOM."

Those skilled in the art would be able to use other algorithms to classify the blocks. Also, they could use a different equations to compute measures of the low-frequency energy, the horizontal energy, and the vertical energy. This algorithm and these equations are given merely for illustration purposes.

**Multiple description image decoder**

The multiple description image decoder works similarly to the multiple description decoder of FIG 9. First, the channel inputs are input to the "Extract variances and N, D for each class" blocks 282, 283, which parses the input bitstream to determine the location of the variances and values of N, D and sends N and the variances to the "Determine Pairing Assignment for each class" block 284. The "Extract variances and N for each class" block 282, 283 also outputs the remaining bitstream parts containing the block classification and DCT coefficients, which is input to the respective entropy decoders 285, 286. The value D is sent from the "Extract variances" 282, 283 elements to the "Demux duplications and pairs from channels and order alternating coefficients" element 287.

Also, the channel inputs are sent to the "Determine which channels working" block 281, which operates as described previously, and outputs the values of the three switches, S1, S2, and S3 to be used by the Inverse Pairing Transforms 298-300. The "Determine which channels working" element 281 also outputs the value $S_3$ to the "Demux ... " 287 for use in identifying the duplicated coefficients.

The "Determine pairing assignment for each class" block 284 outputs the pairing assignment and passes on the values of N and the variances to the block 288 that computes the predictors for each pair and each class using the equations (12) and (13). The predictors are stored in their respective memory locations in the respective Inverse Pairing Transforms 301-303.

The output from the entropy decoding and the block classifications and DCT coefficients are sent to the "Demux duplications and pairs from channel and order alternated coefficients" block 287, which also receives as input the pairing assignment computed previously. The "Demux ..." outputs the duplicated coefficients, which are inverse quantized in inverse quantizers 289-291. If $S_3 = a$ the duplicated coefficients are taken from channel 1. If $S_3 = c$ the duplicated coefficients are taken from channel 2. and If $S_3 = bm$ then they can be taken from either channel. The "Demux..." block 287 outputs the paired coefficients which are inverse quantized using quantizers 291-297 and input to their respective Inverse Pairing Transform 301-303, respectively. The "Demux..." block 287 also outputs the ordered coefficients that were alternated, which are then inverse quantized using quantizers 296-300.

Referring now to FIG 14, the output of the Inverse Pairing Transforms 301-303 are then sent to the "Reorder pairs as samples" block 304, which reorders the pairs in their original coefficient order. Then, the inverse DCT 305 is applied to all the DCT coefficients for the block. Each image-block is sent to the "Reassemble image from blocks" block 306 which outputs the decoded image.

**Claims**

1. A method for coding two samples comprising:

a) transforming the two samples into two coefficients having substantially equal energy;
b) quantizing each of the two coefficients separately; and
c) entropy coding each of the quantized coefficients separately.

2. The method according to claim 1, wherein the transforming step further comprises transforming a first sample (A) and a second sample (B) into a first coefficient (C) and a second coefficient (D) according to the following equations:

$$C = \frac{1}{\sqrt{2}} (A + B),$$

$$D = \frac{1}{\sqrt{2}} (A - B).$$

3. The method according to claim 1, wherein the transforming step further comprises transforming the two samples into two coefficients using a unitary transform.

4. A method for performing multiple description coding on a block of coefficients, comprising the steps of:

a) pairing coefficients within the block of coefficients to form a plurality of coefficient pairs;
b) transforming each coefficient pair into a first transformed coefficient and a second transformed coefficient;
c) quantizing each of the first and second transformed coefficients separately; and
d) assigning the first and second quantized and transformed coefficients to different channels.

5. The method according to claim 4, further comprising the step of:

f) entropy encoding the first and second quantized and transformed coefficients separately prior to transmission.

6. The method according to claim 4, wherein the step of transforming further comprises transforming each coefficient pair (A, B) into a first transformed coefficient (C) and a second transformed coefficient (D) according to the following equation:

$$C = \frac{1}{\sqrt{2}} (A + B),$$

$$D = \frac{1}{\sqrt{2}} (A - B).$$

7. The method according to claim 4, wherein the transforming step further comprises transforming each coefficient pair into the first and second transformed coefficients using a unitary transform such that the first and second transformed coefficients have substantially equivalent energy.

8. The method according to claim 4, wherein the step of pairing further comprises pairing samples with relatively large variances with samples with relatively small variances.

9. The method according to claim 4, wherein the step of pairing further comprises:

(i) ordering the coefficients according to variance from highest to lowest;
(ii) successively pairing each coefficient (A) from a top of the list with a first unpaired coefficient (B) moving down the list whose variance ($\sigma_b^2$) satisfies the following equation:

$$\sigma_b^2 \leq \frac{\sigma_a^2 E_e}{\sigma_a^2 - E_e}$$

where $\sigma_a^2$ is the variance of the coefficient (A) to be paired.

10. The method according to claim 4, wherein the step of pairing further comprises:

(i) ordering the coefficients according to variance from highest to lowest;
(ii) successively assigning a coefficient (A) with the largest variance with a sample (B) from the bottom of the list; and
(iii) deleting the assigned coefficients from the list and repeating steps (i) and (ii) until no coefficients remain on the list.

11. The method according to claim 4, wherein the step of quantizing comprises quantizing each transformed coefficient using a quantization interval that is offset from the other.

12. The method according to claim 4, further comprising the step of controlling the bit size and quantizer step size for each quantizer separately.

13. The method according to claim 12, wherein the step of controlling further comprises maintaining the bit size and the quantizer step size the same for the two quantizers assigned to each coefficient pair.

14. A method for decoding a signal received over two channels using multiple description coding, comprising the steps of:

a) determining which of the two channels are working;
b) entropy decoding each output from the two channels separately;
c) inverse quantizing the output from each of the entropy decoders separately; and
d) inverse pairing and transforming the outputs from the inverse quantizers using information regarding which channels are working..

15. The method according to claim 14, wherein the step of inverse pairing further comprises transforming the outputs (C, D) from the inverse quantizers into two samples according to the following equation:

$$A = \frac{1}{\sqrt{2}} (C + D)$$

$$B = \frac{1}{\sqrt{2}} (C - D).$$

16. The method according to claim 14, wherein the inverse pairing step further comprises transforming the outputs (C, D) from the inverse quantizers into two samples using a unitary transform.

17. A method for coding an image comprising the steps of:

a) decomposing the image into blocks;
b) transforming samples in each block into a block of coefficients;
c) classifying each coefficient block into at least two classes;
d) calculating the variance of the coefficients in the class;
e) determining the number of coefficients to pair and assigning a first plurality of coefficients to be transmitted over both channels;
f) determining the number of coefficients to duplicate and assigning a second plurality of coefficients to be paired and transformed;
g) determining the number of coefficients to alternate and assigning a third plurality of coefficients to be sent over the first channel and a fourth plurality of coefficients to be sent over the second channel;

h) pairing the second plurality of coefficients to form a first plurality of paired coefficients;

i) transforming the first plurality of paired coefficients into a second plurality of paired coefficients;

j) quantizing each coefficient in the first, third, and fourth plurality of coefficients separately;

k) quantizing each coefficient in the second plurality of paired coefficients 1 separately;

l) outputting a quantized version of the first plurality of coefficients to both channels;

m) outputting a quantized version of the third plurality of coefficients to the first channel;

n) outputting a quantized version of the fourth plurality of coefficients to the second channel; and

o) outputting a quantized version of one coefficient of each pair of coefficients within the second plurality of coefficients to the first channel and 1 outputting a quantized version of the other coefficient of each pair of coefficients within the second plurality of coefficients to the second channel.

**18.** The method according to claim 17, further comprising the step of entropy coding each channel separately.

**19.** The method according to claim 17, further comprising sending the classification information in each channel.

**20.** The method according to claim 17, wherein the step of classifying comprises:

a) determining the total energy within each block;

b) determining the low frequency energy within each block;

c) determining the horizontal energy within each block;

d) determining the vertical energy within each block;

e) classifying a block as smooth if most of its energy is low frequency energy or its total energy lies below a predetermined threshold;

f) classifying a block as vertical if most of its energy lies in vertical coefficients;

g) classifying a block as horizontal if most of its energy lies in horizontal coefficients; and

h) classifying a block as random if the block fails to meet the other classifications.

**21.** A method for decoding a coded image sent over two channels comprising:

a) determining which of the two channels are working and controlling a plurality of inverse pairing transformers using this information;

b) extracting a plurality of variances and a number (N) of paired and duplicated (D) coefficients from each channel;

c) determining a pairing assignment for each classification;

d) entropy decoding each received channel separately;

e) computing predictors for each pair and class;

f) demultiplexing the duplicated, paired and alternated coefficients using the number of paired (N) and duplicated (D) coefficients, information regarding which channels are working, the paring assignment and the classifications;

g) inverse quantizing all of the demultiplexed coefficients;

h) inverse pairing and transforming the quantized versions of the paired coefficients and reordering the output;

i) inverse transforming the coefficients; and

j) reassembling the image from the blocks.

*FIG. 1*

PRIOR ART

*FIG. 2*

*FIG. 3*

*FIG. 4*

# FIG. 5

FIG. 6

*FIG. 7*

START — 82

ORDER SAMPLES $X_N$ SO THAT $\sigma_1^2 \geq \sigma_2^2 \geq \cdots \geq \sigma_N^2$ FORM LIST WITH $X_1$ AT TOP AND SET $E_e$ TO BE MAXIMUM TOLERABLE ESTIMATION ERROR — 83

SET M=1 — 84

SELECT $A_m$ FROM TOP OF LIST AND DELETE FROM LIST ASSIGN $\sigma_a^2$ TO BE ITS VARIANCE — 85

86 — IS STACK EMPTY ?  YES

NO

87 — DOSES ELEMENT IN LIST EXIST WITH A VARIANCE $\sigma_b^2 \leq \dfrac{\sigma_a^2 \; E_e}{\sigma_a^2 - E_e}$ ?  NO

SET $B_m = 0$ — 88

YES

ASSIGN LIST ELEMENT WITH LARGEST VARIANCE SATISFYING $\sigma_b^2 \leq \dfrac{\sigma_a^2 \; E_e}{\sigma_a^2 - E_e}$ TO BE $B_M$ DELETE FROM LIST — 89

SET M=M+1  NO — IS STACK EMPTY ? — 90

91

YES

STOP — 92

*FIG. 8*

START — 93

ORDER SAMPLES $X_N$ SO THAT $\sigma_1^2 \geq \sigma_2^2 \geq \cdots \geq \sigma_N^2$ — 94

SET M=1 — 95

ASSIGN $A_M = X_M$
ASSIGN $B_M = X_{N-M+1}$ — 96

SET M=M+1 — 97

IS M > N/2 ? — 98

NO

YES

STOP — 99

FIG. 9

FIG. 10

FIG. 11

EP 0 856 956 A1

*FIG.  12*

140

START — 141

INITIALIZE  E=0;  L=0;  H=0;  V=0;  $T_1$=10 — 142

SET  E= $\sum\limits_{i=1}^{8}$ $\sum\limits_{j=1}^{8}$ $X_{ij}^2$ — 143

SET  L= $\sum\limits_{i=1}^{2}$ $\sum\limits_{j=1}^{2}$ $X_{ij}^2$ — 144

SET  H= $\sum\limits_{j=1}^{8}$ $X_{ij}^2$

SET  L= $\sum\limits_{i=1}^{8}$ $X_{ij}^2$ — 145

SET  $T_2$ = 0.95 x E — 146

IS  $L>T_2$
OR
$E<T_1$ ? — 147

NO →

IS  $V>T_2$ ? — 148

NO →

IS  $H>T_2$ ? — 149

NO →

YES ↓ — 150

YES ↓ — 151

YES ↓ — 152

↓ — 153

ASSIGN CLASS
"SMOOTH"

ASSIGN CLASS
"VERTICAL"

ASSIGN CLASS
"HORIZONTAL"

ASSIGN CLASS
"RANDOM"

START — 154

FIG. 13

$S_1, S_2, S_3,$

DETERMINE WHICH CHANNELS WORKING — 281

288 — COMPUTE PREDICTORS FOR EACH PAIR AND CLASS — PREDICTORS

CHANNEL 1

CHENNAL 2

282 — EXTRACT VARIANCES AND N,D FOR EACH CLASS. 1

283 — EXTRACT VARIANCES AND N.D FOR EACH CLASS. 2

N, VAR.
N, VAR.

284 — DETERMINE PAIRING ASSIGNMENT FOR EACH CLASS

PAIRING ASSIGN.

285 — ENTROPY DECODER 1

CLASS.
COEFFS.
D

286 — ENTROPY DECODER 2

CLASS
COEFFS.

$S_3$

287 — DEMUX DUPLICATIONS AND PAIRS FROM CHANNELS AND ORDER ALTERNATING COEFFICIENTS

$\tilde{X}_1$
$\tilde{X}_2$
$\tilde{X}_D$
$\tilde{C}_1$
$\tilde{D}_1$
$\tilde{C}_2$
$\tilde{D}_2$
$\tilde{C}_{N/2}$
$\tilde{D}_{N/2}$
$\tilde{X}_{D+N+1}$
$\tilde{X}_{D+N+2}$
$\tilde{X}_L$

289 — $IQ_{D_1}$ — $\tilde{X}_1$
290 — $IQ_{D_2}$ — $\tilde{X}_2$
291 — $IQ_{D_D}$ — $\tilde{X}_D$
292 — $IQ_{N_1}$
293 — $IQ_{N_1}$
294 — $IQ_{N_2}$
295 — $IQ_{N_2}$
296 — $IQ_{N_{N/2}}$
— $IQ_{N_{N/2}}$
297 — $IQ_{A_1}$ — $\tilde{X}_{D+N+1}$
298 — $IQ_{A_2}$ — $\tilde{X}_{D+N+2}$
299
300 — $IQ_{A_L}$ — $\tilde{X}_L$

301 — IPT1 — $\tilde{A}_1$ / $\tilde{B}_1$
302 — IPT2 — $\tilde{A}_2$ / $\tilde{B}_2$
303 — IPT N/2 — $\tilde{A}_{N/2}$ / $\tilde{B}_{N/2}$

TO FIG.14

## FIG. 14

$\tilde{X}_1$     $\tilde{X}_1$
$\tilde{X}_2$     $\tilde{X}_2$
$\vdots$
$\tilde{X}_D$     $\tilde{X}_D$

$\tilde{A}_1$   305   $\tilde{X}_{D+1}$
$\tilde{B}_1$     $\tilde{X}_{D+2}$
$\tilde{A}_2$     $\tilde{X}_{D+3}$
$\tilde{B}_2$     $\tilde{X}_{D+4}$
$\vdots$
$\tilde{A}_{N/2}$
$\tilde{B}_{N/2}$     $\tilde{X}_{D+N}$
$\tilde{X}_{D+N+1}$     $\tilde{X}_{D+N+1}$
$\tilde{X}_{D+N+2}$     $\tilde{X}_{D+N+2}$
$\vdots$
$\tilde{X}_L$     $\tilde{X}_L$

(FROM FIG.13)

RECORDER PAIRS AS SAMPLES

305

INVERSE DCT

306

REASSEMBLE IMAGE FROM BLOCKS

IMAGE OUTPUT

EP 0 856 956 A1

**European Patent Office**

## EUROPEAN SEARCH REPORT

Application Number

EP 98 30 0067

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| P,X | Y. WANG ET AL.: "Multiple description image coding for noisy channels by pairing transform coefficients" IEEE FIRST WORKSHOP ON MULTIMEDIA SIGNAL PROCESSING, 23 - 25 June 1997, NY USA, pages 419-424, XP002065136 * the whole document * | 1-8 | H04B7/08 H03M7/40 |
| P,X | ORCHARD ET AL.: "Redundancy rate-distortion analysis of multiple description coding using paiwise correlating transforms" PROCCEDINGS OF THE INTERNATIONAL CONFERENCE ON IMAGE PROCESSING, vol. 1, 26 - 29 October 1997, LOS ALAMITOS USA, pages 608-611, XP002065137 * paragraph 1 * * paragraph 2.1 * | 1,3 | |
| A | EP 0 482 864 A (FUJITSU) 29 April 1992 * column 1, line 30 - column 4, line 24 * * column 6, line 13 - column 8, line 7 * | 1,4 | TECHNICAL FIELDS SEARCHED (Int.Cl.6) H04B H03M H04N |
| A | VAISHAMPAYAN: "Design of multiple description scalar quantizers" IEEE TRANSACTIONS ON INFORMATION THEORY, vol. 39, no. 3, May 1993, NY USA, page 821-834 XP000038024 * paragraph III * | 11,12 | |

The present search report has been drawn up for all claims

| Place of search | Date of completion of the search | Examiner |
|---|---|---|
| MUNICH | 19 May 1998 | Augarde, E |